# EUROPEAN PATENT APPLICATION

(11) **EP 4 484 360 A1**
(43) Date of publication of application: **01.01.2025**
(21) Application number: 23182271.9
(22) Date of filing: 29.06.2023
(51) Int. Cl.: B81C 99/00

(54) **LITHOGRAPHIC MASKING DEVICE AND PARALLEL-FLOW PROVIDER DEVICE FOR A STOP FLOW LITHOGRAPHY APPARATUS**

(71) Applicant: Technische Universität München, 80333 München (DE)
(72) Inventor: TAIEDINEJAD, Ebrahim, 80333 München (DE); DESTGEER, Ghulam, 80333 München (DE); SAHIN, Mehmet Akif, 80333 München (DE); WERNER, Helen, 80333 München (DE); DIETZEL, Andreas, 80333 München (DE); ERFLE, Peer, 80333 München (DE)
(74) Representative: Lucke, Andreas

(57) **Abstract**

A lithographic masking device for a stop flow lithography apparatus comprises a substrate, a lithographic mask arranged above the substrate, and a first flow channel defining an inner volume thereof. The substrate is adapted to transmit blue or UV light, wherein the blue or UV light comprises a wavelength in a wavelength range from 320 nm to 500 nm. Side portions and an upper portion of the first flow channel are arranged above the substrate, such that the inner volume of the flow channel is arranged above the lithographic mask and that a shortest distance between the lithographic mask and the inner volume of the first flow channel is at most 30 µm.

## Description

### TECHNICAL FIELD

The disclosure relates to improvements in stop flow lithography, in particular to improve the size and shape control over the produced polymer particles, such as by improving the lithographic resolution and/or the control over the parallel flow of the precursor-containing fluids.

### BACKGROUND

In stop flow lithography, a flow of a fluid containing a photochemical precursor is generated in a flow channel with a sub-millimeter diameter. This flow is temporarily stopped, such that the precursor-containing fluid is temporarily static inside the flow channel. While this is the case, the precursor-containing fluid is irradiated through a lithographic mask with blue or UV light to photo-induce a polymerization of the irradiated precursor. This process generates, from the polymerized precursor, polymer particles in the flow channel, with shapes determined by both the lithographic mask and the shape of the static, precursor-containing fluid in the flow channel. However, if the fluid is not perfectly static during the irradiation but still flows to some degree, this smears out the shape of the generated polymer particles. In other words, the accuracy to which the flow is stopped and becomes static, or to which a - typically undesired - flow remains, respectively, also determines the shape of the generated polymer particles.

After the polymer particles have been generated, the flow of the precursor-containing fluid in the flow channel is restarted. The flow transports the generated polymer particles away from the region with the irradiation through the lithographic mask, and provides non-polymerized precursor-containing fluid to this region. The flow is stopped again, and the process is iterated. The generated polymer particles are collected at the end of the flow channel.

### OVERVIEW

In view of the technical problems laid out above, there is a need for improvements in stop flow lithography. This objective is achieved with a lithographic masking device according to claim 1, a parallel-flow provider device according to claim 5, a stop flow lithography apparatus according to claim 9, a stop flow lithography method according to claim 11, and with polymer particles according to claim 14. The dependent claims refer to advantageous embodiments.

In a first aspect, a lithographic masking device for a stop flow lithography apparatus comprises a substrate, a lithographic mask arranged above the substrate, and a first flow channel defining an inner volume thereof. The substrate is adapted to transmit blue or UV light, wherein the blue or UV light comprises a wavelength in a wavelength range from 320 nm to 500 nm. Side portions and an upper portion of the first flow channel are arranged above the substrate, such that the inner volume of the first flow channel is arranged above the lithographic mask and that a shortest distance between the lithographic mask and the inner volume of the first flow channel is at most 30 µm.

The upper portion of the first flow channel may alternatively be referred to as the upper wall of the first flow channel.

The side portions of the first flow channel may alternatively be referred to as the side walls of the first flow channel.

The first flow channel may be adapted to guide a flow through the first flow channel along the first direction.

The substrate may be adapted to transmit at least one wavelength in the wavelength range from 320 nm to 500 nm, for example, with a transmittance of at least 30% or at least 50% or at least 70%.

As compared to the prior art, this arrangement reduces the distance between the lithographic mask and the inner volume of the flow channel, or to the polymer containing precursor which may be arranged therein, respectively, and thus improves the resolution of the lithographic process step. Consequently, the shape control over the generated polymer particles is improved, and particles can be fabricated with a higher resolution or with smaller sizes, in particular with sizes smaller than 100 µm.

The short distance may be achieved by an additive process, such as 3D printing or two-photon printing, the side portions and the upper portion of the first flow channel onto the substrate with the lithographic mask arranged thereover. In contrast, in the prior art, the flow channel is produced separately from the lithographic mask, and the lithographic mask is added to the stop flow apparatus at a later stage. Consequently, in the prior art, the distance between the lithographic mask and the inner volume of the flow channel is at least in the range of a wall thickness of the flow channel, which is typically at least 100 µm. This large distance limits the lithographic resolution of the prior art devices.

According to some embodiments, the inner volume of the first flow channel is in direct physical contact with the lithographic mask and/or the lithographic mask is arranged inside the inner volume of the first flow channel.

This reduces the distance between the lithographic mask and the inner volume of the flow channel further, improving the resolution of the lithographic process step even further.

In some embodiments, the side portions and/or the upper portion of the first flow channel comprise(s) or is/are composed of a polymer material.

A corresponding material composition is directly related to the additive manufacturing process of the side portions and/or the upper portion of the first flow channel.

According to some embodiments, the side portions and/or the upper portion of the first flow channel are planar; and/or the first flow channel comprises a rectangular or quadratic inner cross section and/or outer cross section.

The planar or rectangular geometry minimizes deflections and undesirable scattering of the blue or UV light, improving the resolution of the stop flow lithography.

A footprint of the lithographic mask on the substrate may be fully comprised in a footprint of the first flow channel on the substrate.

The lithographic mask may comprise openings for transmitting the blue or UV light. A footprint of the openings on the substrate may be fully comprised in a footprint of the first flow channel on the substrate, in particular between left and right inner walls of the first flow channel. Alternatively, or in addition, the features described with respect to the footprint on the substrate may be present in a projection onto a horizontal reference plane arranged between the substrate and the upper channel wall.

In corresponding embodiments, blue or UV light is transmitted through the lithographic mask only in the region of the flow channel; otherwise the blue or UV light is blocked by the lithographic mask. This minimizes stray light which might otherwise vagrantly reach the inner volume of the flow channel. Thus, corresponding embodiments improve the size and shape control over the generated polymer particles in the stop flow lithography process.

The first flow channel may extend along a first direction defined by a center line extending along the longitudinal direction of the first flow channel through its center.

The lithographic mask may comprise openings.

The openings may comprise first slit-shaped portions, wherein longitudinal axes of the first slit-shaped portions are orientated perpendicular to the first direction.

The openings may comprise second slit-shaped portions, wherein the second slit-shaped portions are connected to the first slit-shaped portions and/or extend away from the first slit-shaped portions.

Widths of the openings and/or of the first slit-shaped portions and/or of the second slit-shaped portions may be less than 100 µm.

Corresponding openings beneficially support the generation of polymer particles whose shapes are optimized according to requirements in microbiological and medical applications.

The lithographic mask may comprise or may be composed of a metal, such as gold or silver, or of ZnO.

A thickness of the lithographic mask may be at most 1 µm.

A lithographic mask with such a small thickness can be arranged between the substrate and the first flow channel without interfering with the additive production process for the side portions and/or the upper portion of the first flow channel.

The lithographic masking device may further comprise a first valve adapted to stop the parallel flows of the fluids, wherein, optionally, the first valve may be arranged in the first flow channel or in a downstream extension of the first flow channel.

In a second aspect, a parallel-flow provider device for providing parallel flows of fluids for a stop flow lithography apparatus comprises a second flow channel and at least three nozzle structures. The second flow channel comprises at least four inlet openings for introducing fluids into the second flow channel. The second flow channel extends along a second direction. The at least three nozzle structures are arranged in the second flow channel in series along the second direction. The nozzle structures comprise respective nozzle structure outlets, nozzle structure inlets, and nozzle structure bodies. The nozzle structure bodies provide fluid-connections between the nozzle structure inlets and the respective nozzle structure outlets. The inlet openings and the nozzle structure inlets are arranged alternatingly one after the other along the second direction.

The second direction may be defined by a line extending along the second flow channel through its center, for example, parallel to a direction of a fluid flow through the second flow channel.

The second flow channel may be adapted to guide a flow through the second flow channel along the second direction.

A respective device provides four parallel flows of four fluids in a flow channel. This is particularly beneficial for generating polymer particles for applications in microbiological and medical applications: An inner parallel flow may be a flow of a fluid without a photochemical precursor, resulting in a cavity of the generated polymer particles. The second inner flow may be a flow of a fluid comprising a photochemical precursor for a hydrophilic polymer, resulting in a hydrophilic inner wall of the cavity. The third inner flow may be a flow of a fluid comprising a photochemical precursor for a lipophilic (or hydrophobic, respectively) polymer, resulting in a lipophilic outer surface of the generated polymer particles. The outermost flow may be a flow of a fluid without a precursor, defining the outer shape of the generated polymer particles.The arrangement of the inlet openings and of the nozzle structures, in particular of the nozzle structure inlets, permits to provide the corresponding flows with a high precision of their respective cross sections, or with an improved control over the shape of the generated polymer particles, respectively.

A width or a diameter of the nozzle structure outlets or of at least one of the nozzle structure outlets may be in a range from 60 µm to 90 µm, or in a range from 65 µm to 85 µm, or in a range from 70 µm to 80 µm.

A corresponding width or diameter beneficially balances between providing a high resolution of the parallel flows or the generated polymer particles, respectively, on the one hand, and a reasonably small flow resist on the other hand. When smaller nozzle structure outlets are used, the increased flow resist slows down the flow of the fluids through the nozzle structures and hence the fabrication speed.

The parallel-flow provider device may comprise fluid connections to the inlet openings.

The inlet openings may comprise a first, second, third, and fourth inlet opening arranged consecutively along a downstream direction of the second flow channel, such that the first inlet opening is the most upstream and the fourth inlet opening is the most downstream.

The fluid connections may provide respective flow resists.

The flow resists provided by the fluid connections may increase along the downstream direction, such that the fluid connection to the first inlet opening provides the smallest flow resist, and the fluid connection to the fourth inlet opening provides the largest flow resist.

The increasing flow resists reduce the pressure differences in the parallel-flow provider device when the flow through the second flow channel is stopped, and thus reduces undesired, remaining flows.

In some embodiments, the fluid connections may extend away from the inlet openings.

In some embodiments, the parallel-flow provider device comprises at least three or at least four respective fluid connections.

The parallel-flow provider device may further comprise at least two or at least three or at least four inlet valves. Each of the inlet valves may be associated with, in particular fluid-connected to, a corresponding one of the inlet openings for selectively stopping the introduction of the fluids into the second flow channel through the respective inlet openings.

The fluid connections to the inlet openings may comprise or may be fluid connections between the inlet valves and the inlet openings.

In conventional devices, a single valve is provided in the flow channel for stopping the parallel flows. In contrast, the inlet valves associated with the individual inlet openings allow for stopping the inflow of the fluids into the second flow channel individually and according to a predefined sequence. This improves the reliability and the ideality of the stopping of the parallel flow of the fluids, i.e., it minimizes the undesired, remaining flow. As laid out above, this improves the resolution of the stop flow lithography process. Moreover, the parallel flow of the fluids can be stopped and restarted faster, resulting in an enlarged throughput of the polymer particle fabrication process.

The fluid connections between the inlet valves and the associated inlet openings may provide respective flow resists. The flow resists provided by the fluid connections may increase along the downstream direction, such that the fluid connection to the first inlet opening provides the smallest flow resist, and the fluid connection to the fourth inlet opening provides the largest flow resist.

A corresponding arrangement efficiently prevents pressure differences at the inlet valves, and thus prevents the fluids to flow from one inlet valve (where the pressure would conventionally be the highest) to another (where the pressure would be the lowest) when the flow is stopped. Consequently, the flow is stopped quickly and reliably when the inlet valves are closed.

The parallel-flow provider device may further comprise a flow diffusor. The flow diffusor may be arranged along the second direction between any of the nozzle structure inlets and the nozzle structure outlet of the same nozzle structure, such that an inlet opening is arranged along the second direction between the flow diffusor and said nozzle structure inlet.

The flow diffusor improves the parallelism of the parallel flows of the fluids and hence the control over their cross sections, and thus over the cross sections of the generated polymer particles.

The flow diffusor may comprise annular discs with openings. The annular discs may be arranged between the respective nozzle structure body and an inner wall of the second flow channel.

The openings of different annular discs of the same flow diffusor may be misaligned with each other.

A corresponding setup provides an efficient and reliable flow diffusor.

The nozzle structures may comprise a first, second, and third nozzle structure. The parallel-flow provider device may comprise a respective flow diffusor associated with the first nozzle structure, a respective flow diffusor associated with the second nozzle structure, and/or a respective flow diffusor associated with the third nozzle structure.

The nozzle structures and/or the flow diffusor(s) and/or the second flow channel may comprise or may be composed of a polymer.

The corresponding structures may be fabricated in the same process step or with the same fabrication technique, in particular with an additive fabrication technique such as 3D printing or two photon printing.

The nozzle structures may comprise a first, second, and third nozzle structure arranged consecutively along a downstream direction of the second flow channel, such that the first nozzle structure is the most upstream and the third nozzle structure is the most downstream.

The first nozzle structure and the second nozzle structure may be spaced apart from each other along the second direction, and/or the second nozzle structure and the third nozzle structure may be spaced apart from each other along the second direction.

Such a geometry allows for individual tailoring and optimization of the nozzle structures, for example to control the inner shapes and the outer shapes of the generated polymer particles independently.

The first nozzle structure may comprise an inner flow channel with a non-circular cross section; and/or the nozzle structure outlet of the first nozzle structure may comprise a non-circular cross section; and/or the second nozzle structure may comprise an inner channel with a non-circular cross section; and/or the nozzle structure outlet of the second nozzle structure may comprise a non-circular cross section; and/or the third nozzle structure may comprise an inner channel with a non-circular cross section; and/or the nozzle structure outlet of the third nozzle structure may comprise a non-circular cross section.

By tailoring the shapes of the inner flow channels or the nozzle structure outlets of the nozzle structure(s), parallel flows of fluids and hence polymer particles can be generated according to a predefined, almost arbitrarily selected cross section of the parallel flows of the fluids to be achieved. Hence, polymer particles may be provided specifically with shapes according to the requirements of a given microbiological or medical application.

The nozzle structures may comprise internal flow channels and center lines extending along the internal flow channels in the centers of the flow channels. At least one pair of the nozzle structures may be arranged with an offset between their respective center lines.

A corresponding setup permits to shape the parallel flows of the fluids and hence the generated polymer particles in terms of their cross sections.

The second flow channel may comprise a first center line extending along the second direction in the center of the second flow channel. The nozzle structures may comprise internal flow channels and center lines associated therewith. At least one or at least two of the nozzle structures may be arranged with an offset between the first center line and the center line(s) associated with the respective internal flow channel(s).

A corresponding setup permits to shape the parallel flows of the fluids and hence the generated polymer particles in terms of their cross sections.

According to a third aspect, a stop flow lithography apparatus comprises the parallel-flow provider device described above and the lithographic masking device described above, wherein the first flow channel and the second flow channel are fluid-connected.

In a corresponding stop flow lithography device, the improved lithographic resolution of the stop flow lithography apparatus and the improved shaping and stopping of the parallel flows of the fluids of the parallel-flow provider device act together synergetically, resulting in an optimized size and shape control over the generated polymer particles.

The first flow channel and the second flow channel may form a single flow channel, in particular a linear single flow channel.

The stop flow lithography apparatus may further comprise a light source for generating blue or UV light.

The light source may be a pulsed light source, in particular, with a pulse duration of < 1 ms, or with a pulse duration of < 0.1 ms, or with a pulse duration of < 0.01 ms.

The blue or UV light may comprise a wavelength in a wavelength range from 320 nm to 500 nm.

The light source may be arranged to provide and/or shine and/or guide the blue or UV light through the substrate and the lithographic mask into the first flow channel.

In embodiments with the inlet valves, the stop flow lithography apparatus may further comprise fluid providing systems fluid-connected to the inlet valves, such that the stop flow lithography apparatus is adapted to provide respective fluids from the fluid providing systems to the respective associated inlet openings selectively via the inlet valves.

The fluid providing systems may comprise respective fluid reservoirs, respective fluid pumps, and fluid connections between the respective fluid reservoirs and the respective fluid pumps.

The fluid pumps may be syringe pumps, and/or the fluid pumps may be adapted to provide fluid currents which are controllable and/or temporarily constant.

The stop flow lithography apparatus may comprise a reference point arranged in the first flow channel above the lithographic mask. The fluid connections between the fluid pumps and the fluid reservoirs may be formed such that their flow resists match the flow resists between the respective fluid pumps and the reference point.

According to a fourth aspect, a stop flow lithography method is provided for fabricating polymer particles. The method comprises providing parallel flows of fluids from a second flow channel; receiving the parallel flows of the fluids in a first flow channel, wherein the first flow channel is formed above a lithographic mask which is arranged above a substrate; and stopping the parallel flows of the fluids using a valve. The parallel flows of the fluids comprise at least one inner flow of a fluid comprising a photochemical precursor. The method further comprises providing blue or UV light through the substrate and the lithographic mask in the first flow channel to photopolymerize at least a portion of the photochemical precursor thus forming the polymer particles, wherein the blue or UV light comprises a wavelength in a wavelength range from 320 nm to 500 nm.

The providing the blue or UV light through the substrate and the lithographic mask in the first flow channel may comprise or refer to guiding and/or shining the blue or UV light through the substrate and the lithographic mask into the first flow channel

The second flow channel may comprise inlet openings. The providing the parallel flows of fluids may comprise introducing the fluids to the second flow channel through the inlet openings.

Inlet valves may be associated with the inlet openings. The stopping the parallel flows of the fluids may be performed using the inlet valves.

In some embodiments, fluid connections may be provided between the inlet valves and the respective inlet openings.

The second flow channel may extend along a second direction.

The parallel flows of the fluids may be provided in the second flow channel along the second direction according to a downstream direction of the parallel flows of fluids.

The inlet openings may be arranged along the second direction one after the other according to the following sequence in the downstream direction: a first inlet opening, a second inlet opening, a third inlet opening, and a fourth inlet opening.

In the process step of closing the inlet valves, the inlet valve associated with the first inlet opening may close the first inlet opening before the inlet valve associated with the second inlet opening closes the second inlet opening, and/or the inlet valve associated with the second inlet opening may close the second inlet opening before the inlet valve associated with the third inlet opening closes the third inlet opening, and/or the inlet valve associated with the third inlet opening may close the third inlet opening before the inlet valve associated with the fourth inlet opening closes the fourth inlet opening.

A corresponding sequence of closing the inlet valves results in a faster stopping of the parallel flows of the fluids, and hence in enhanced shape control and an enhanced throughput of the particle fabrication.

Fluid providing systems may be fluid-connected to the inlet valves.

The introducing the fluids to the second flow channel through the inlet openings may comprise fluid-connecting the fluid providing systems to the inlet openings to introduce the fluids to the second flow channel from the fluid providing systems via the inlet valves. The closing the inlet valves may stop the introducing the fluids to the second flow channel from the fluid providing systems.

The method may further comprise building up pressures in the fluid providing systems to introduce the fluids from the fluid providing systems to the second flow channel.

The method may further comprise maintaining the built-up pressures when the inlet valves disconnect the fluid providing systems from the inlet openings.

Alternatively, or in addition, the pressures may be built up in the fluid providing systems such that pressures at the inlet valves match when the inlet valves connect the fluid providing systems to the inlet openings.

A first valve may be provided in the first flow channel or in a downstream extension of the first flow channel. The stopping the parallel flows of the fluids may comprise closing the first valve, wherein the first valve is closed after closing the inlet openings using the inlet valves.

According to a fifth aspect, polymer particles are dispersed in a fluid. Sizes of the polymer particles may be in a range from 80 to 95 µm along at least one direction.

The polymer particles may comprise first portions. The first portions of the polymer particles may correspond to an extrusion of a base by a height. The sizes of the polymer particles may refer to said height.

The polymer particles may comprise second portions extending away from the first portions and adapted for bending towards the first portions.

Corresponding second portions allow for flexibly capturing and enclosing a hydrophilic droplet in a microbiological or a medical application.

The particles may comprise outer surfaces and inner cavities. Inner surfaces may be associated with the inner cavities. One of the outer surfaces and the inner surfaces may be hydrophilic and the other hydrophobic. In particular, the inner surfaces may be hydrophilic and the outer surfaces may be hydrophobic.

Corresponding polymer particles are particularly beneficial for applications in microbiology and medicine, where the dispersing fluid is hydrophobic and a droplet to be captured is hydrophilic.

### BRIEF DESCRIPTION OF THE FIGURES

The techniques of the present disclosure and the advantages associated therewith will be best apparent from a description of exemplary embodiments in accordance with the accompanying drawings, in which:
- Fig. 1A: gives a sectional view of a lithographic masking device according to a first embodiment;
- Fig. 1B: gives a sectional view of a lithographic masking device according to a second embodiment;
- Fig. 1C: gives a sectional view of a lithographic masking device according to a third embodiment;
- Fig. 2A: gives a top view of the lithographic masking device according to the first embodiment;
- Fig. 2B: gives a top view of the lithographic masking device according to the second embodiment;
- Fig. 2C: gives a top view of the lithographic masking device according to the third embodiment;
- Fig. 3A: gives a top view of a lithographic mask;
- Fig. 3B: gives a top view of a modified lithographic mask;
- Fig. 3C: gives a top view of another modified lithographic mask;
- Fig. 4: gives a sectional view of a parallel-flow provider device according to an embodiment;
- Fig. 5a: gives a photograph of a stop parallel-flow provider device according to another embodiment;
- Fig. 5b: gives two close-ups of the parallel-flow provider device according to the embodiment of Fig. 5a;
- Fig. 6: gives a sectional view of a parallel-flow provider device according to another embodiment;
- Fig. 7a: shows the temporal evolution of the flow upon stopping it in a parallel-flow provider device according to an embodiment;
- Fig. 7b: shows the temporal evolution of the flow upon stopping it in a parallel-flow provider device according to another embodiment;
- Fig. 8a: illustrates annular discs with openings of a flow diffusor;
- Fig. 8b: illustrates a flow diffusor;
- Fig. 9a: illustrates an alternative flow diffusor;
- Fig. 9b: illustrates the flow of a fluid in the presence of the flow diffusor of Fig. 9a;
- Fig. 10a: illustrates a nozzle structure;
- Fig. 10b: illustrates an alternative nozzle structure;
- Fig. 10c: illustrates an alternative nozzle structure;
- Fig. 10d: illustrates an alternative nozzle structure;
- Fig. 10e: illustrates an alternative nozzle structure;
- Fig. 10f: illustrates an alternative nozzle structure;
- Fig. 11: illustrates cross-sections of the parallel flows of the fluids provided by the parallel-flow provider;
- Fig. 12a: gives a sectional view of a parallel-flow provider device according to another embodiment;
- Fig. 12b: illustrates cross-sections of parallel flows of the fluids provided by the parallel-flow provider according to the embodiment of Fig. 12a;
- Fig. 13: gives a perspective view of a stop flow lithography apparatus according to an embodiment;
- Fig. 14: gives a sectional view of a stop flow lithography apparatus according to another embodiment;
- Fig. 15: gives a perspective view of a stop flow lithography apparatus according to another embodiment;
- Fig. 16a: illustrates a fluid providing system;
- Fig. 16b: illustrates flow resists related to the stop flow lithography apparatus according to Fig. 14 and with the fluid providing system of Fig. 16a;
- Fig. 17: illustrates a stop flow lithography method;
- Fig. 18a: gives a side view of a polymer particle according to an embodiment;
- Fig. 18b: gives a sectional view of the polymer particle of Fig. 18a;
- Fig. 19a: gives a side view of a polymer particle according to another embodiment;
- Fig. 19b: gives a sectional view of the polymer particle of Fig. 19a;
- Fig. 20a: illustrates a polymer particle according to another embodiment; and
- Fig. 20b: illustrates a polymer particle according to another embodiment.

### DETAILED DESCRIPTION OF EMBODIMENTS

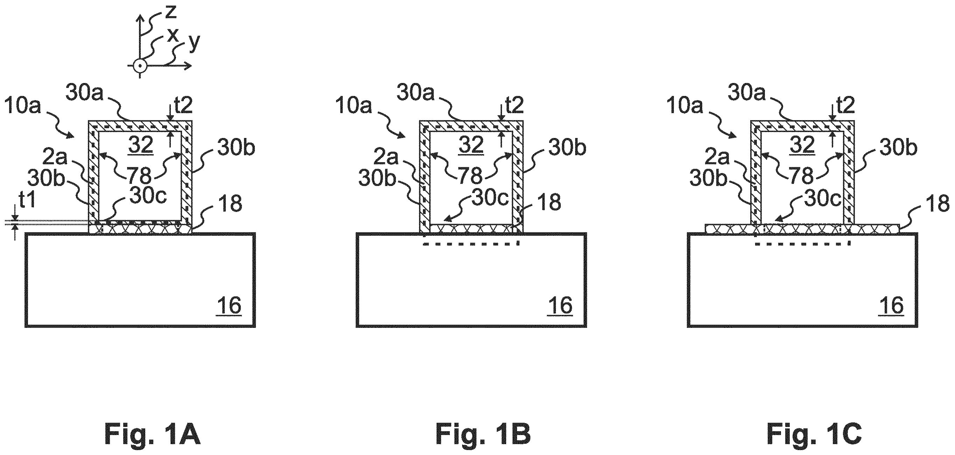

Fig. 1A, Fig. 1B, and Fig. 1C give cross-sectional views of lithographic masking devices 10a according to three different embodiments.

Each of the lithographic masking devices 10a of Fig. 1A, Fig. 1B, and Fig. 1C comprises a lithographic mask 18 arranged above a substrate 16.

Side portions (side walls) 30b and an upper portion (upper wall) 30a of a first flow channel 2a are arranged above the substrate 16 along the direction z. The side portions 30b provide inner side walls 78 of the first flow channel 2a.

In the embodiment of Fig. 1A, the first flow channel 2a is formed by the side portions 30b, the upper portion 30a, and a bottom portion (bottom wall) 30c thereof. The bottom portion 30c has a first thickness t1 of no more than 30 µm. This first thickness t1 is smaller than a second thickness t2 of the side portions 30b and of the upper portion 30a.

In the embodiment of Fig. 1B, the first flow channel 2a is formed by the side portions 30b, the upper portion 30a, and the substrate 16.

In the embodiment of Fig. 1C, the first flow channel 2a is formed by the side portions 30b, the upper portion 30a, a section of the lithographic mask 18, and the substrate 16. The substrate is adapted to transmit blue or UV light, i.e., when blue or UV is shone through the substrate 16 from below, the substrate 16 transmits at least one wavelength in a wavelength range from 320 nm to 500 nm, for example, with a transmittance of at least 30%. Preferably, the transmittance for said wavelength is at least 50% or at least 70%.

In Fig. 1A, Fig. 1B, and Fig. 1C, the first flow channel 2a encloses an inner volume 32 for a flow of a fluid, or for the parallel flows of fluids occurring in a lithography apparatus, respectively. The first flow channel 2a extends along the first direction x.

The lithographic masking devices 10a of Fig. 1A, Fig. 1B, and Fig. 1C are fabricated by providing the substrate 16, forming the lithographic mask 18 above the substrate 16, and, thereafter, forming the side portions 30b and the upper portions 30a of the first flow channel 2a above the substrate to define the inner volume 32 of the first flow channel 2a. Therein, the side portions 30b and the upper portions 30a are formed in their final positions (relative to the lithographic mask 18 and the substrate 16) by an additive process, such as 3D printing or two photon printing. This permits to form the first flow channel 2a without a bottom portion (Fig. 1B, Fig. 1C) or with a bottom portion 30c with a reduced thickness t1. In the state-of-the-art, in contrast, a channel is formed spatially separate from a lithographic mask, and the two are brought together at a later stage of the fabrication process. Consequently, the conventional channel is formed with a bottom portion having the full thickness of the rest of the channel, which is typically 100 µm or more. This results in a distance of 100 µm or more between the lithographic mask and the inner volume of the channel in the conventional device, thus limiting the resolution that can be achieved lithographically. In the lithographic masking device 10a according to this description, the distance between the lithographic mask in the inner volume 32 of the first flow channel 2a is reduced to 30 µm or less, and the lithographic resolution is improved. Furthermore, in the embodiments without a bottom portion 30c (Fig. 1B, Fig. 1C), the number of interfaces that blue or UV light coming from below (i.e., from the -z direction) needs to pass before reaching the inner volume 32 of the first flow channel 2a is reduced.

The lithographic mask 18 is formed above/onto the substrate by deposition of a metal or of ZnO through a shadow mask, e. g. from the gas phase, to a thickness of 0.1 µm.

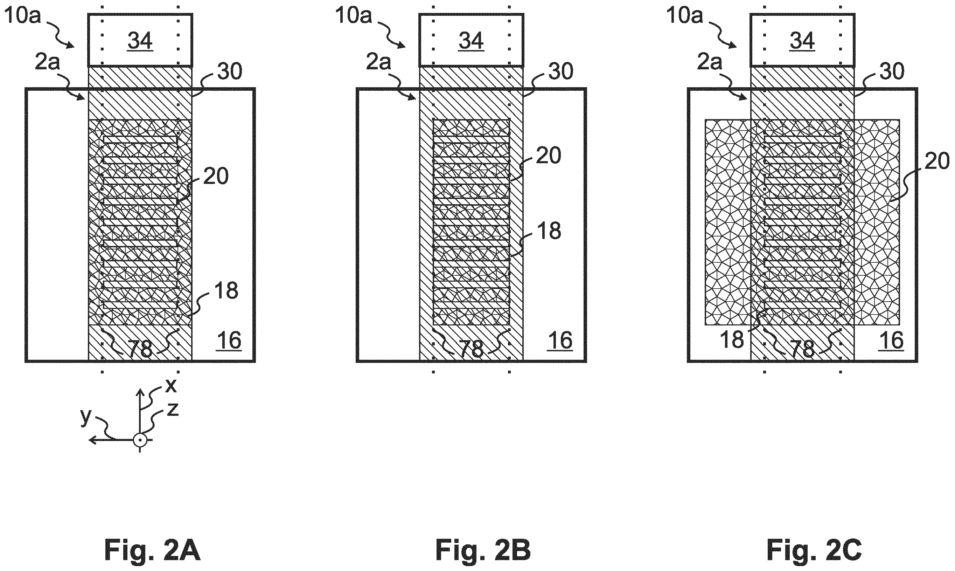

Fig. 2A, Fig. 2B, and Fig. 2C give top views of lithographic masking devices 10a according to the respective embodiments of Fig. 1A, Fig. 1B, and Fig. 1C.

Moreover, in Fig. 2A, Fig. 2B, and Fig. 2C, a first valve 34 in the first flow channel 2a is depicted. The first valve 34 serves to stop the fluid flow through the first flow channel 2a.

In the top views of Fig. 2A, Fig. 2B, and Fig. 2C, openings 20 of the lithographic mask 18 are well visible.

In the following, the term "footprint" of an element is used to refer to a projection of the respective element onto the substrate 16 along the vertical direction z, which is perpendicular to the substrate 16 (and to the first direction x, along which the first flow channel 2a extends).

In the embodiment of Fig. 2A, the footprint of the openings 20 is fully comprised in the footprint of the inner volume 32 of the first flow channel 2a. In other words, the openings 20 are located between the inner side walls 78 in the top view of Fig. 2A. This arrangement is preferable, since the openings 20 only permit that light to pass through the lithographic mask 18, which is needed in the inner volume 32 of the first flow channel 2a for photopolymerization. Unnecessary stray light is avoided.

In the embodiment of Fig. 2B, the footprint of the openings 20, and also the footprint of the lithographic mask 18 is fully comprised in the footprint of the inner volume 32 of the first flow channel 2a. In other words, the openings 20 and the lithographic mask 18 are located between the inner side walls 78 in the top view of Fig. 2B. In yet other words, the lithographic mask 18 is arranged in the inner volume 32 of the first flow channel 2a. This arrangement is even more preferable. It provides the advantages laid out above in the context of Fig. 2A. Moreover, the side walls 30b can be formed directly onto the substrate 16, improving the mechanical integrity of the lithographic masking device 10a.

In the embodiment of Fig. 2C, the footprint of the lithographic mask 18 exceeds the footprint of the first flow channel 2a. Although less desirable, corresponding embodiments are possible. In other embodiments (not shown) the footprint of the openings 20 may exceed the footprint of the first flow channel 2a, even though this is preferably avoided.

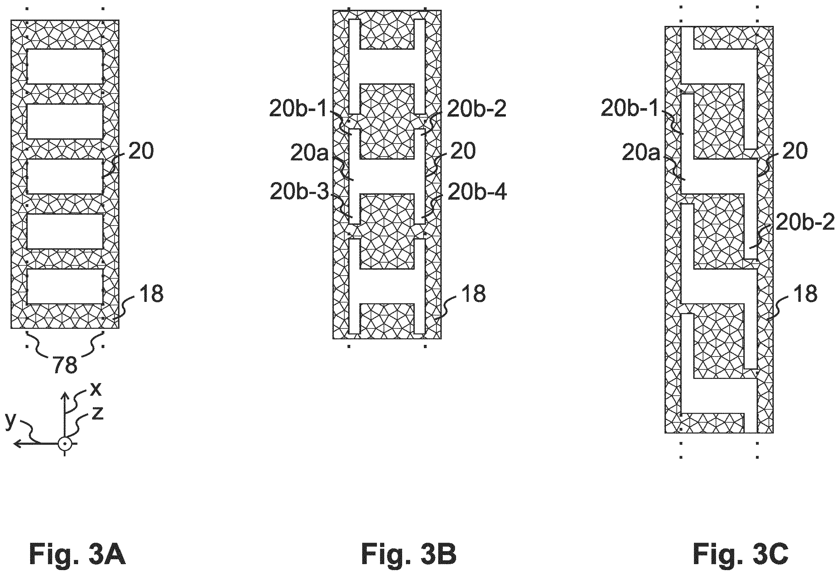

Fig. 3A, Fig. 3B, and Fig. 3C give top views of lithographic masks 18.

According to Fig. 3A, the openings 20 are slit-shaped, with widths of 100 µm or less. They are orientated with their long axes y perpendicular to the first direction x of the first flow channel 2a.

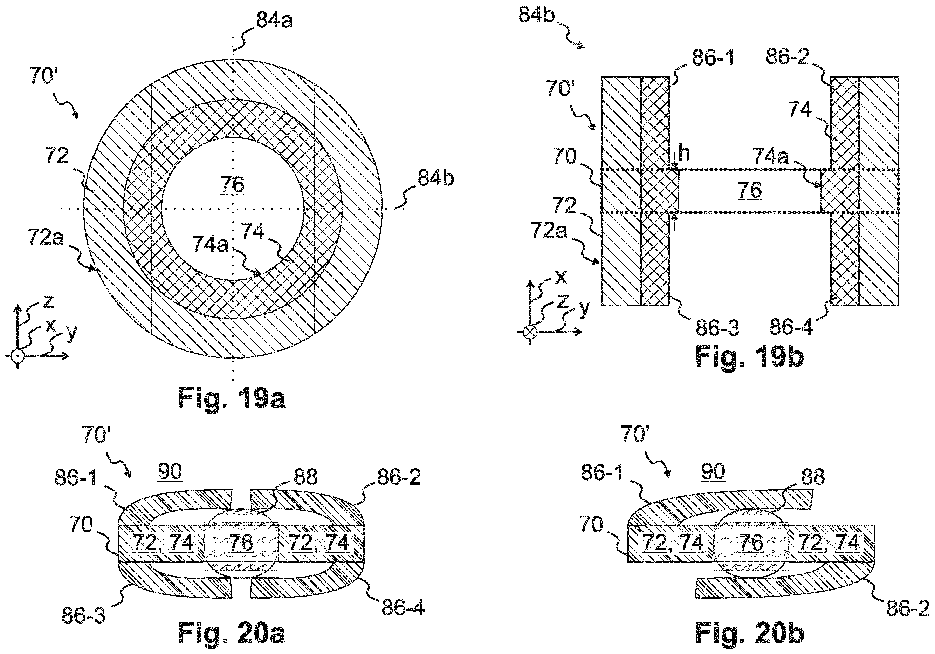

The openings 20 of the lithographic mask 18 of Fig. 3b comprise first slit-shaped portions 20a similar to the openings 20 of Fig. 3A. In addition, the openings 20 comprise second slit-shaped portions 20b-1, 20b-2, 20b-3, 20b-4 extending away from the first slit-shaped portions 20a along the first direction x of the first flow channel 2a. These portions serve to create polymer particles with complex shapes, i.e., with second portions 86-1, 86-2, 86-3, 86-4, which will be described in detail in the context of Fig. 19a, Fig. 19b, Fig. 20a, Fig. 20b.

The lithographic mask 18 of Fig. 3C is similar to the one of Fig. 3B. However, it comprises only two second slit-shaped portions 20b-1, 20b-2, as opposed to the four second slit-shaped portions 20b-1, 20b-2, 20b-3, 20b-4 of the lithographic mask 18 of Fig. 3B. Alternative embodiments (not shown) comprise any one or any combination of the second slit-shaped portions 20b-1, 20b-2, 20b-3, 20b-4 of the lithographic mask 18 of Fig. 3B.

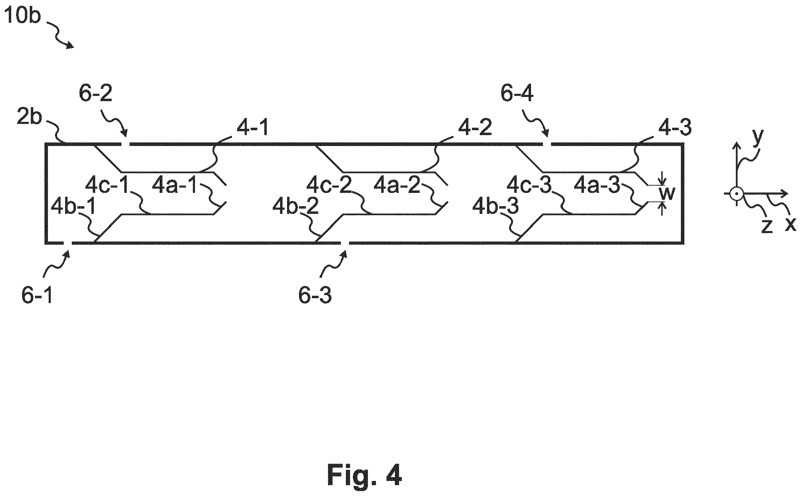

Fig. 4 gives a sectional view of a parallel-flow provider device 10b according to an embodiment.

The parallel-flow provider device 10b comprises a second flow channel 2b.

Nozzle structures 4-1, 4-2, 4-3 are arranged in series (i.e., one after the other) and spaced apart from each other along the second direction x of the second flow channel 2b.

Inlet openings 6-1, 6-2, 6-3, 6-4 permit to introduce fluids through them into the second flow channel 2b.

Each of the nozzle structures 4-1, 4-2, 4-3 comprises a respective nozzle structure inlet 4b, 4b-1, 4b-2, 4b-3.

Each of the nozzle structures 4-1, 4-2, 4-3 comprises a respective nozzle structure outlet 4a, 4a-1, 4a-2, 4a-3.

Each of the nozzle structures 4-1, 4-2, 4-3 comprises a respective nozzle structure body 4c, 4c-1, 4c-2, 4c-3. The nozzle structure bodies 4c, 4c-1, 4c-2, 4c-3 provide fluid-connections between the nozzle structure inlets 4b, 4b-1, 4b-2, 4b-3 and the respective nozzle structure outlets 4a, 4a-1, 4a-2, 4a-3.

The nozzle structures 4-1, 4-2, 4-3 have inner diameters of 60 µm to 75 µm. The overall length of a nozzle structure body 4c, 4c-1, 4c-2, 4c-3 and a nozzle structure outlet 4a, 4a-1, 4a-2, 4a-3 is 0.5 mm.

Each of the nozzle structure inlets 4b, 4b-1, 4b-2, 4b-3 is arranged between two inlet openings 6-1, 6-2, 6-3, 6-4 along the direction x.

Consequently, when fluids are introduced through the inlet openings 6-1, 6-2, 6-3, 6-4, the nozzle structures 4-1, 4-2, 4-3 serve to shape those fluids into parallel flows. In more detail, fluids provided through the first three inlet openings 6-1, 6-2, 6-3 pass through at least one of the nozzle structures 4-1, 4-2, 4-3 and are shaped into inner flows of the parallel flows of the fluids. A fluid introduced through the fourth inlet opening 6-4 is shaped into an outer parallel flow surrounding the inner flows. During operation, at least one of the fluids introduced through the first three inlet openings 6-1, 6-2, 6-3 is provided with a photochemical precursor for photopolymerization. The fluid introduced through the fourth inlet opening 6-4 is provided without the precursor. When the parallel flows of the fluids are then illuminated to trigger/provide the photopolymerization, the precursor in the inner flow(s) forms the polymer particles, whereas no photopolymerization occurs in the outer flow. When, after the illumination, the flows continue, the outer flow serves as a carrier flow to transport the generated polymer particles through the second flow channel 2b.

The cross sections of the second flow channel 2b and of the nozzle structures 4-1, 4-2, 4-3 are tailored to sculpt the parallel flows of the fluids into a predefined cross section, corresponding to the cross sections of the polymer particles generated in the stop flow lithography.

In the depicted embodiment, the cross section of the second flow channel 2b is circular with a diameter of 0.2 mm, and the cross section of the nozzle structures 4-1, 4-2, 4-3 is circular with diameters w of the outlets 4a, 4a-1, 4a-2, 4a-3 of 75 µm, respectively.

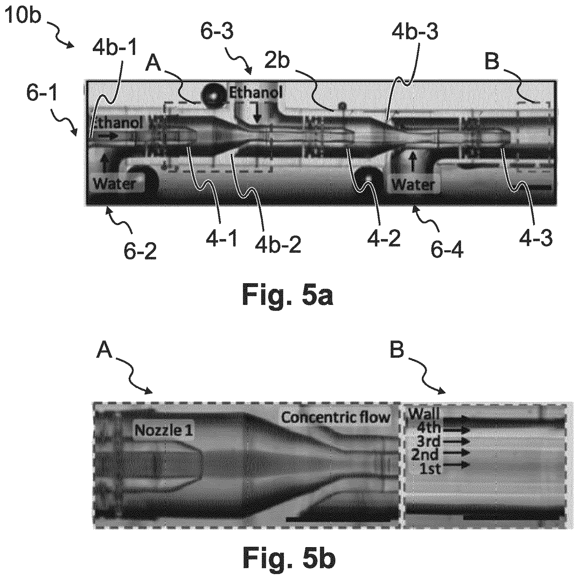

Fig. 5a gives a photograph of a parallel-flow provider device 10b according to an embodiment reflecting a prototype.

The parallel-flow provider device 10b of Fig. 5a is similar to the one of Fig. 4.

For illustrative purposes, ethanol and water are alternatingly introduced through the inlet openings 6-1, 6-2, 6-3, 6-4 into the second flow channel 2b. Because of their different refractive indices, ethanol and water can be distinguished in the photograph and the parallel flows of the fluids (i.e., of the ethanol in the water) are visualized.

Fig 5b gives close-ups of the photograph of Fig. 5a, corresponding to regions A and B therein. Indicated in B are the 1^{st}, 2^{nd}, 3^{rd}, and 4^{th} parallel flow, i.e., the flows resulting from the fluids introduced through the 1^{st}, 2^{nd}, 3^{rd}, and 4^{th} inlet openings 6-1, 6-2, 6-3, 6-4, respectively. As can be seen in the photographs, the parallel-flow provider device 10b provides a high-quality, parallel flow of the respective fluids.

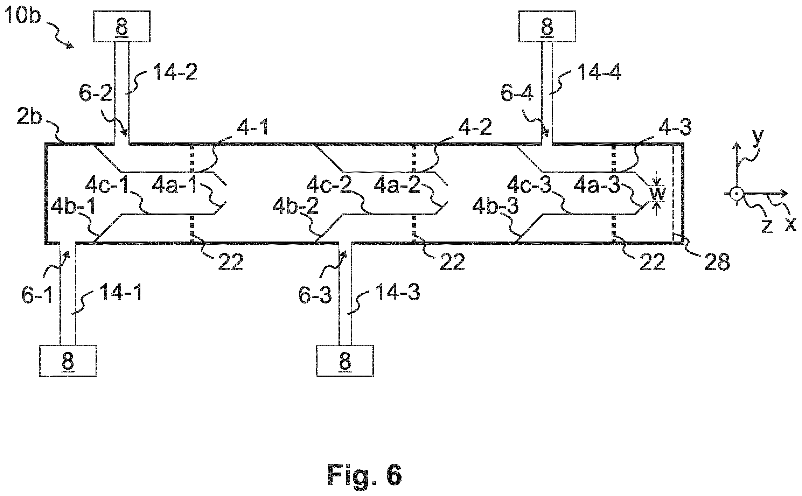

Fig. 6 gives a sectional view of a parallel-flow provider device 10b according to another embodiment, which is similar to the embodiment of Fig. 4.

The parallel-flow provider device 10b further comprises flow diffusers 22, which improve the parallelism of the parallel flows provided by the parallel-flow provider device 10b.

The parallel-flow provider device 10b further comprises inlet valves 8, which are connected via fluid connections 14-1, 14-2, 14-3, 14-4 to the inlet openings 6-1, 6-2, 6-3, 6-4, respectively.

In a conventional stop flow lithography apparatus, a single valve is provided in a flow channel to stop the parallel flows of the fluids. The provision of the inlet valves 8 gives much better control over the dynamics of stopping the parallel flows. Consequently, with the inlet valves 8, the parallel flows can be stopped faster, resulting in an increased throughput.

In particular, to stop the flow through the second flow channel 2b, the inlet valves are closed according to the arrangement of the associated inlet openings 6-1, 6-2, 6-3, 6-4 from the upstream to the downstream direction. In other words, the most upstream inlet valve 8, i.e., the inlet valve 8 associated with the most upstream inlet opening 6-1, is closed first, and the most downstream inlet valve 8, i.e., the inlet valve 8 associated with the most downstream inlet opening 6-4, is closed last. This sequence ensures a fast and reliable stopping of the flow through the second flow channel 2b.

The fluid connections 14, 14-1, 14-2, 14-3, 14-4 provide respective flow resists, which increase along the downstream direction from the first fluid connection 14-1 to the fourth fluid connection 14-4. The flow resists serve to bring the pressures at the upstream ends of the fluid connections 14, 14-1, 14-2, 14-3, 14-4, or at the inlet valves 8, respectively, closer to each other, reducing undesirable flows from one of the upstream ends of the fluid connections 14, 14-1, 14-2, 14-3, 14-4, or a respective inlet valve 8, respectively (where the pressure would be higher without the increasing flow resists) to another one of the upstream ends of the fluid connections 14, 14-1, 14-2, 14-3, 14-4, or another one of the inlet valves 8, (where the pressure would be lower) upon stopping the parallel flows of the fluids using the valves 8, 34. Thus, the flow resists provided by the fluid connections 14, 14-1, 14-2, 14-3, 14-4 result in a faster, temporarily sharper stopping of the parallel flows of the fluids.

Also, a reference y-z-plane 28 is indicated in Fig. 6.

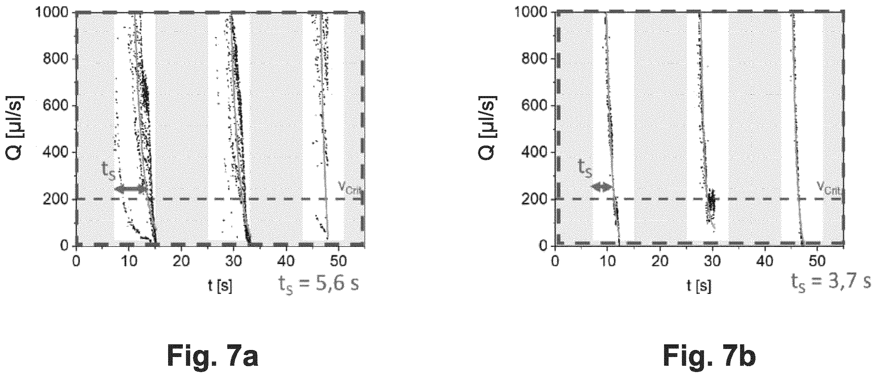

Fig. 7a and Fig. 7b illustrate the dynamics of the total flow Q (i.e., the sum of the parallel flows) through the second flow channel 2b upon opening and closing the valves 8, 34, as obtained by simulations. Fig. 7a refers to a parallel-flow provider device 10b with equal flow resists of the fluid connections 14, 14-1, 14-2, 14-3, 14-4. Fig. 7b refers to a parallel-flow provider device 10b with increasing flow resists of the fluid connections 14, 14-1, 14-2, 14-3, 14-4 as described above.

During the gray shaded time intervals in Fig. 7a, Fig. 7b, the valves 8, 34 are open. During the white (not gray shaded) time intervals in Fig. 7a, Fig. 7b, the valves 8, 34 are closed.

A flow stopping time tₛ is defined by a critical flow vCr of the flow Q, and, more specifically, by the time it takes the total flow Q to drop to this value vCr when the valves 8, 34 are closed.

For the parallel-flow provider device 10b of Fig. 7a with the equal flow resists of the fluid connections 14, 14-1, 14-2, 14-3, 14-4, the flow stopping time tₛ amounts to 5.6 s.

For the parallel-flow provider device 10b of Fig. 7b with the increasing flow resists of the fluid connections 14, 14-1, 14-2, 14-3, 14-4, the flow stopping time tₛ is significantly reduced and amounts to only 3.7 s.

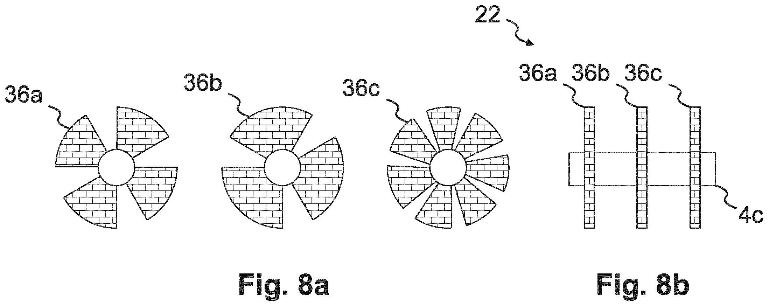

Fig. 8a illustrates annular discs 36a, 36b, 36c with openings for a flow diffusor 22. Fig. 8b illustrates the assembled flow diffusor 22 using the annular discs 36a, 36b, 36c with openings.

As illustrated in Fig. 8a, the discs 36a, 36b, 36c comprise different numbers of openings. Consequently, when they are mounted one after the other to the nozzle structure body 4c as illustrated in Fig. 8b, the openings are misaligned with respect to each other.

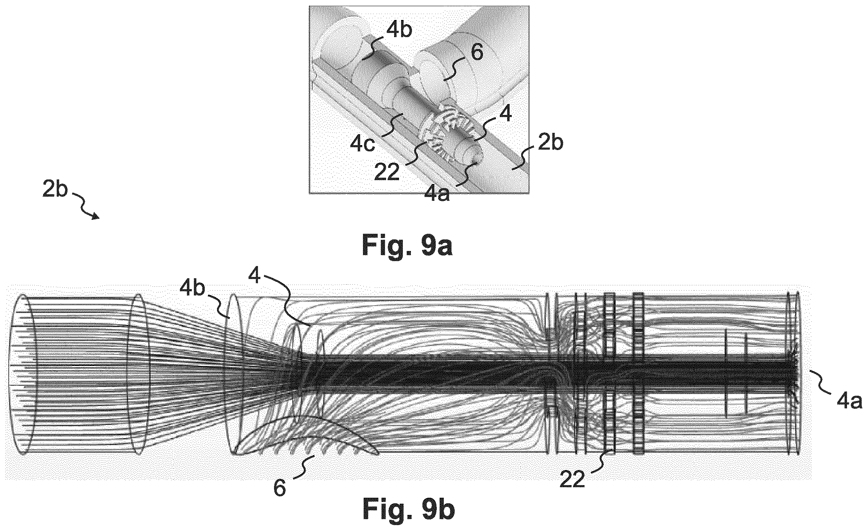

Fig. 9a illustrates a flow diffusor 22 similar to the one of Fig. 8b. Fig. 9b illustrates the flow of a fluid for the second flow channel 2b in a vicinity of the flow diffusor 22 of Fig. 9a as obtained by simulation.

As can be seen in Fig. 9b, the flow diffusor 22 efficiently converts the turbulent flow upstream (i.e., to the left in Fig. 9b) of the flow diffusor 22 into a parallel, laminar flow downstream (i.e., to the right in Fig. 9b) of the flow diffusor 22.

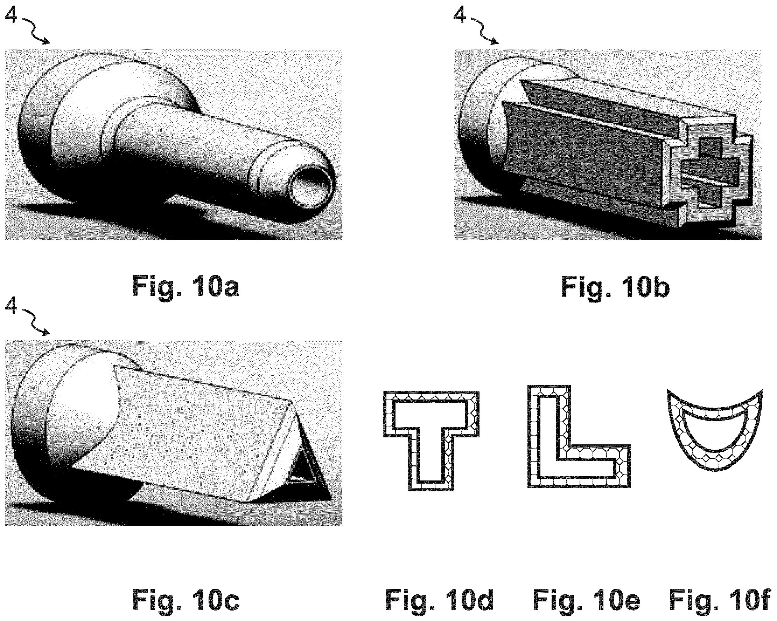

Fig. 10a, Fig. 10b, Fig. 10c, Fig. 10d, Fig. 10e, Fig. 10f illustrate possible cross sections of the nozzle structure 4.

The cross sections are: Fig. 10a: circular; Fig. 10b: cross-shaped; Fig. 10c: triangular; Fig. 10d: T-shaped; Fig. 10e: L-shaped; Fig. 10f: quarter-moon-shaped or half-moon-shaped; not shown: rectangular or quadratic.

According to the embodiments of Fig. 10b, Fig. 10c, the nozzle structure outlet 4a and the nozzle structure body 4c are provided with noncircular cross sections. According to alternative embodiments (not shown), the nozzle structure inlet 4b is provided with the noncircular cross section as well. According to yet other embodiments (not shown), only the nozzle structure outlet 4a is provided with a noncircular cross section, whereas the nozzle structure inlet 4b and the nozzle structure body 4c are provided with circular cross sections.

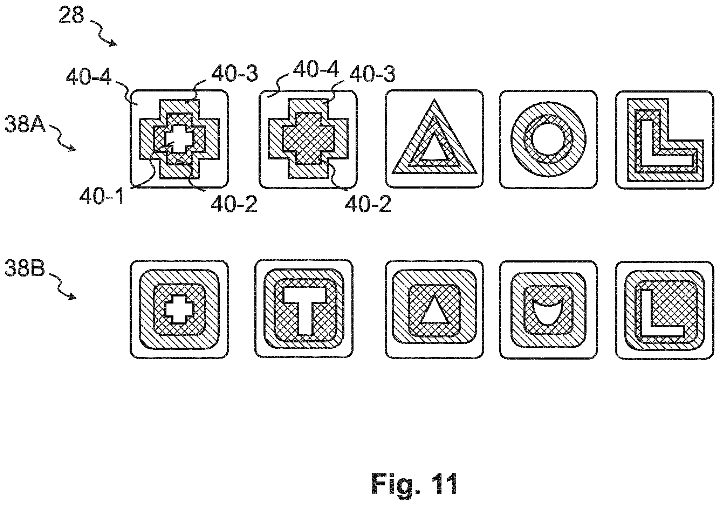

Fig. 11 illustrates possible cross-sections of the parallel flows of the fluids provided by the parallel-flow provider 10b in the reference y-z-plane 28 indicated in Fig. 6, for different cross sections of the nozzle structures 4.

Each panel in Fig. 11 corresponds to one embodiment of the parallel-flow provider 10b, with a specific geometry of its nozzle structures 4.

In each panel, the flow 40-1 corresponds to the fluid introduced into the second flow channel 2b through the first inlet opening 6-1, which has passed through the first, second, and third nozzle structures 4-1, 4-2, 4-3 prior to reaching the reference y-z-plane 28.

In each panel, the flow 40-2 corresponds to the fluid introduced into the second flow channel 2b through the second inlet opening 6-2, which has passed through the second and third nozzle structures 4-2, 4-3 prior to reaching the reference y-z-plane 28.

In each panel, the flow 40-3 corresponds to the fluid introduced into the second flow channel 2b through the third inlet opening 6-3, which has passed through the third nozzle structure 4-3 prior to reaching the reference y-z-plane 28.

In each panel, the flow 40-4 corresponds to the fluid introduced into the second flow channel 2b through the fourth inlet opening 6-4, which provides the outer parallel flow and which has passed through none of the nozzle structures.

When a stop flow lithography apparatus comprising the parallel-flow provider device 10b is used to fabricate polymer particles, the flow 40-4 does not comprise a photochemical precursor. The outer flow 40-4 serves as a carrier flow. The (inner) flow 40-3 comprises a photochemical precursor for a hydrophilic or a hydrophobic polymer. The (inner) flow 40-2 comprises a photochemical precursor for a hydrophobic or a hydrophilic polymer, complementary to the flow 40-3. The (inner) flow 40-1 does not comprise a photochemical precursor. Preferably, the (inner) flow 40-3 comprises the photochemical precursor for the hydrophobic polymer, and the (inner) flow 40-2 comprises the photochemical precursor for the hydrophilic polymer.

When the parallel flows 40-1, 40-2, 40-3, 40-4 are stopped and illuminated with the blue or UV light, the inner flow 40-2 is photopolymerized into a hydrophilic (or alternatively, into a hydrophobic) portion of the generated polymer particle. The inner flow 40-3 is photopolymerized into a hydrophobic (or alternatively, into a hydrophilic) portion of the generated polymer particle. No photopolymerization occurs in the (inner) flow 40-1, which does not comprise the photochemical precursor, and a cavity of the generated polymer particle is formed at the position of the (inner) flow 40-1.

The panels in the upper row 38A depict cross-sections in the reference y-z-planes 28 of parallel-flow providers 10b, whose third nozzle structures 4-3 have noncircular cross sections, except for the fourth cross section from the left in the upper row 38A, which corresponds to a circular cross section. The nozzle structures 4-1, 4-2 may have the same cross-sections as the third nozzle structure 4-3, or they may have circular cross sections.

The cross section of the third nozzle structure 4-3 determines the outer shapes of all the three inner flows 40-1, 40-2, 40-3.

The panels in the lower row 38B depict cross-sections in the reference y-z-planes 28 of parallel-flow providers 10b, whose first nozzle structure 4-1 has a noncircular cross section.

The cross section of the first nozzle structure 4-1 determines the outer shape of the inner flow 40-1, but leaves the inner flows 40-2, 40-3 widely unaffected.

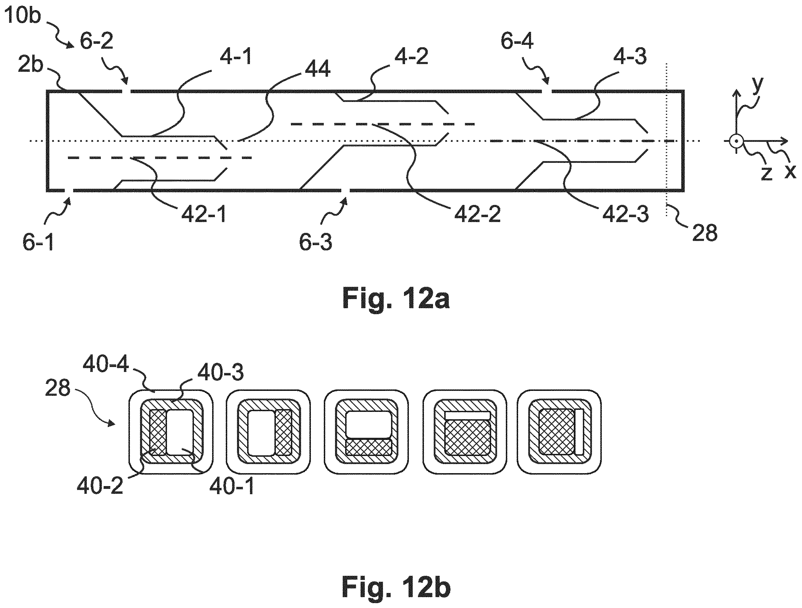

Fig. 12a gives a sectional view of a parallel-flow provider device 10b according to another embodiment, which is similar to the embodiments of Fig. 4 and of Fig. 6. Fig. 12b illustrates possible cross-sections of the parallel flows of the fluids provided by the parallel-flow provider 10b in the reference y-z-plane 28 indicated in Fig. 12a, for different offsets of the nozzle structures 4.

In Fig. 12a, a first center line 44 of the second flow channel 2b is indicated. The first center line 44 is merely a reference, but not a physical element of the second flow channel 2b. It extends along the second direction x of the second flow channel 2b in its center.

Moreover, center lines 42-1, 42-2, 42-3 of the nozzle structures 4-1, 4-2, 4-3 are indicated. The center lines 42-1, 42-2, 42-3 are merely references, but not physical elements of the second flow channel 2b. They extend through internal flow channels of the nozzle structures 4-1, 4-2, 4-3 in the respective centers of the internal flow channels.

With reference to any pair of the nozzle structures 4-1, 4-2, 4-3 in Fig. 12a, the nozzle structures 4-1, 4-2, 4-3 of the respective pair are arranged such that their center lines 42-1, 42-2, 42-3 have an offset. The offset may be defined as a distance in a plane perpendicular to the first center line 44 between the points where the center lines 42-1, 42-2, 42-3 intersect the respective plane. In the depicted embodiments, the first center line 44 is orientated along the x direction, and the respective plane is the y-z-plane.

In alternative embodiments (not shown) only two pairs of the nozzle structures 4-1, 4-2, 4-3 have an offset between their center lines 42-1, 42-2, 42-3, and another pair of the nozzle structures 4-1, 4-2, 4-3 is arranged without an offset between their center lines 42-1, 42-2, 42-3.

In Fig. 12a, the first and second nozzle structures 4-1, 4-2 are arranged in the second flow channel 2b with an offset between their respective center lines 42-1, 42-2 and the first center line 44. In contrast, the third nozzle structure 4-1 is arranged without an offset between its center line 42-3 and the first center line 44.

In alternative embodiments (not shown) only one of the nozzle structures 4-1, 4-2, 4-3 is arranged in the second flow channel 2b with an offset between its respective center line 42-1, 42-2, 42-3 and the first center line 44. In yet other embodiments (not shown) the (i.e., three) nozzle structures 4-1, 4-2, 4-3 are arranged in the second flow channel 2b with an offset between their respective center lines 42-1, 42-2, 42-3 and the first center line 44.

Fig. 12b illustrates cross-sections of the parallel flows of the fluids provided by the parallel-flow provider 10b of Fig. 12a in the reference y-z-plane 28 for different offsets of the center lines 42-1, 42-2, 42-3 of the nozzle structures 4-1, 4-2, 4-3, both with respect to pairs of the nozzle structures 4-1, 4-2, 4-3 and/or with respect to the first center line 44. For a detailed description of the elements 40-1, 40-2, 40-3, 40-4, reference is made to the similar Fig. 11.

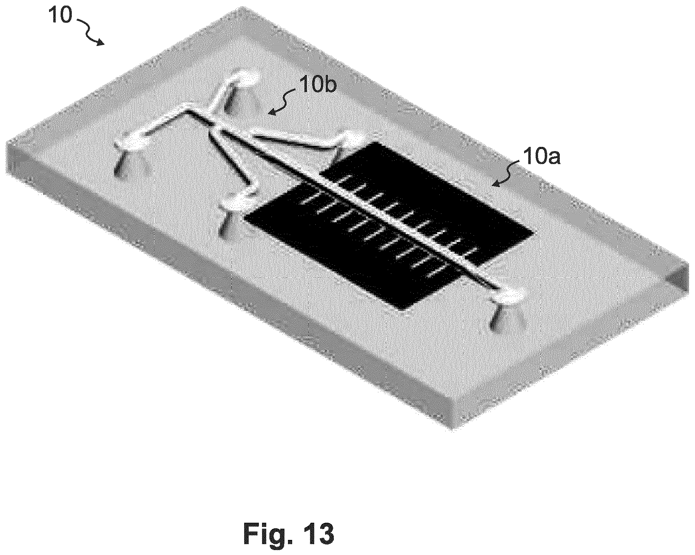

Fig. 13 gives a perspective view of a stop flow lithography apparatus 10 according to an embodiment.

The stop flow lithography apparatus 10 comprises a lithographic masking device 10a similar to the lithographic masking devices 10a described above, and a parallel-flow provider device 10b similar to the parallel-flow provider devices 10b described above.

The stop flow lithography apparatus 10 has a length of 17 mm and a width of 9 mm.

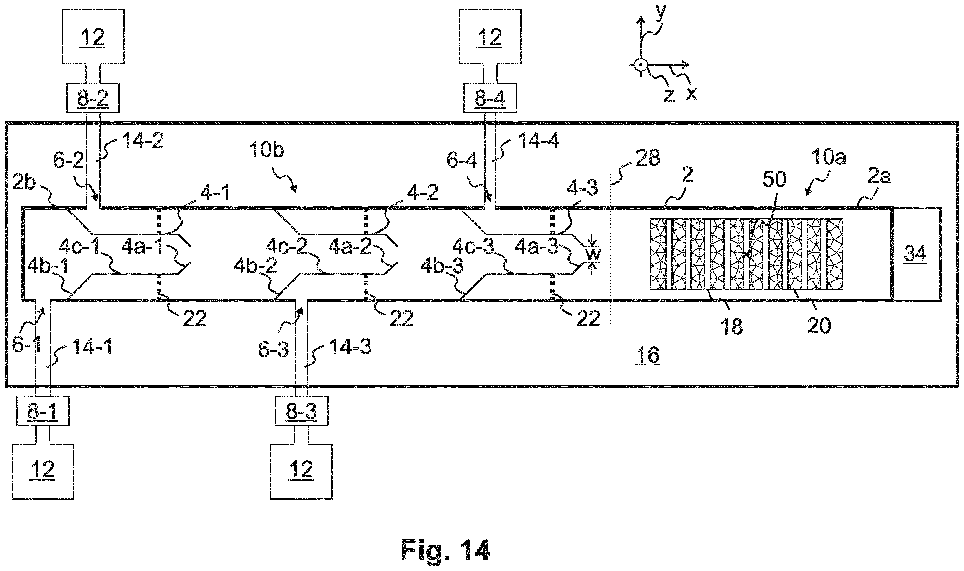

Fig. 14 gives a sectional view of a stop flow lithography apparatus 10 according to a second embodiment.

The stop flow lithography apparatus 10 comprises a lithographic masking device 10a similar to the lithographic masking device 10a of Fig. 1B, Fig. 2B, and a parallel-flow provider device 10b similar to the parallel-flow provider device 10b of Fig. 6, which are described in detail above in the context of the corresponding figures.

The first flow channel 2a of the lithographic masking device 10a is fluid-connected to the second flow channel 2b of the parallel-flow provider device 10b to form a single, linear flow channel 2. The lithographic masking device 10a and the parallel-flow provider device 10b are formed onto/above a common substrate 16.

The stop flow lithography apparatus 10 of Fig. 14 is formed by providing a substrate 16 transparent to blue or UV light, such as boron crown glass or silica glass. In some embodiments, the substrate comprises vertical through holes for providing fluid connections, such as shown in Fig. 13. The lithographic mask 18 is then formed by depositing metal or ZnO to a thickness of 0.1 mm through a shadow mask onto the substrate 16. Subsequently, the second flow channel 2b and the side portions 30b and the upper portion 30c of the first flow channel 2a are formed onto/above the substrate using a single additive fabrication process, such as 3D printing or two photon printing.

In Fig. 14, a reference point 50 is defined above the lithographic mask 18.

The stop flow lithography apparatus 10 comprises fluid providing systems 12 fluid-connected to the inlet valves 8, 8-1, 8-2, 8-3, 8-4 to provide fluids to the associated inlet openings 6, 6-1, 6-2, 6-3, 6-4 selectively via the inlet valves 8, 8-1, 8-2, 8-3, 8-4. The inlet valves 8, 8-1, 8-2, 8-3, 8-4 serve to selectively interrupt the flow of fluids from the fluid providing systems 12 to the associated inlet openings 6, 6-1, 6-2, 6-3, 6-4 to stop the parallel flows of the fluids in a stop flow lithography process.

To stop the flow through the flow channel 2, the inlet valves 8-1, 8-2, 8-3, 8-4 are closed according to their arrangement along the downstream direction, as described above. After closing the inlet valves 8-1, 8-2, 8-3, 8-4, the first valve 34 is closed.

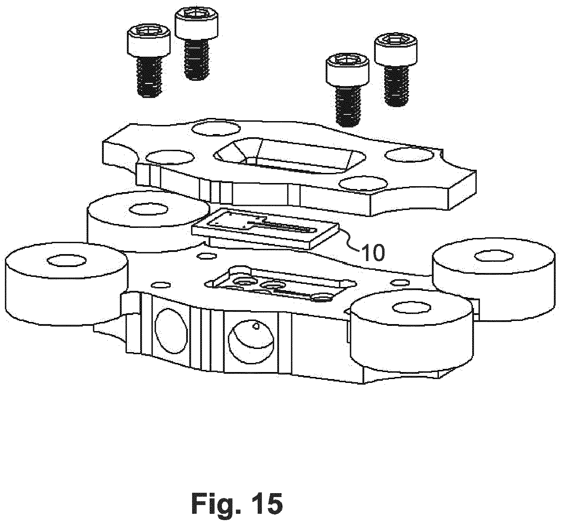

Fig. 15 gives a perspective view of a stop flow lithography apparatus according to another embodiment. It encompasses the stop flow lithography apparatus 10 of Fig. 13, indicated by the reference numeral 10 in Fig. 15.

In the embodiment of Fig. 15, a housing is provided to fluid connect the vertical through holes in the substrate of the stop flow lithography apparatus 10 of Fig. 13 to corresponding connecting ports of the housing. The connecting ports serve to connect the vertical through holes and hence the inlet openings 6, 6-1, 6-2, 6-3, 6-4 to the inlet valves 8 and to the fluid providing systems 12.

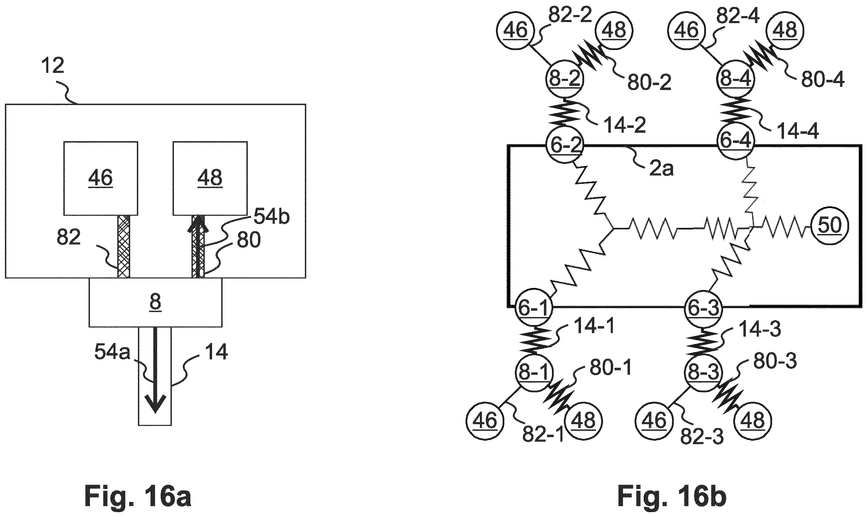

Fig. 16a and Fig. 16b illustrate the fluid providing system 12 and its influence on the flow resists in the stop flow lithography apparatus 10.

The fluid providing system 12 comprises a fluid pump 46 and a fluid reservoir 48. The fluid pump 46 is a syringe pump 46. It is connected to the fluid reservoir 48 via the inlet valve 8, which is of the type of a three-way valve 8. The three-way valve 8 selectively provides a flow path 54a from the fluid pump 46 to the respective inlet opening 6 via the fluid connections 82, 14; or a flow path 54b from the fluid pump 46 to the respective fluid reservoir 48 via the fluid connections 82, 80.

First, the operation of the fluid providing system 12 to stop the flow through the flow channel 2 is described: The inlet valve 8 is controlled to disconnect the fluid providing system 12 from the inlet opening 6, or to close the inlet opening 6, respectively. For this purpose, it switches from the flow path 54a to the flow path 54b. During the entire stop flow lithography process, the syringe pump 46 is operated to provide a pressure. Hence, when it is connected to the fluid reservoir 48 by the flow path 54b, the pressure in the fluid providing system 12 as generated by the syringe pump 46 is maintained.

In the following, the operation of the fluid providing system 12 to restart the flow through the flow channel 2 is described: The inlet valve 8 is controlled to connect the fluid providing system 12 to the inlet opening 6 via the flow path 54a. For this purpose, it switches from the flow path 54b to the flow path 54a. As the pressure in the fluid providing system 12 has been maintained while the flow through the flow channel 2 was stopped, the fluid providing system 12 immediately provides pressure and fluid to the inlet opening 6 upon the switching to the flow path 54a. This is an advantage over the state-of-the-art, wherein the inlet valves 8 are not provided and the fluid pump is switched on and off during the stop flow lithography process. The immediate provision of the pressure and the fluid to the inlet opening 6 speeds up the overall stop flow lithography process and enhances its throughput.

To further improve the speed and the reliability of the stopping and the restarting the flow through the flow channel 2, flow resists of the fluid connections 14, 14-1, 14-2, 14-3, 14-4; 80, 80-1, 80-2, 80-3, 80-4; 82, 82-1, 82-2, 82-3, 82-4 are selected as illustrated in Fig. 16b.

In Fig. 16b, zig-zag lines indicate the flow resists of the corresponding fluid connections 14, 14-1, 14-2, 14-3, 14-4; 80, 80-1, 80-2, 80-3, 80-4; 82, 82-1, 82-2, 82-3, 82-4.

Additional zig-zag lines indicate the flow resists between the inlet openings 6, 6-1, 6-2, 6-3, 6-4 and the nozzle structures 4, 4-1, 4-2, 4-3, from the nozzle structure 4-1 to the nozzle structure 4-2, from the nozzle structure 4-2 to the nozzle structure 4-3, and from the nozzle structure 4-3 to the reference point 50. The flow resists indicated by the additional zig-zag lines are dictated by the design of the parallel-flow provider device 10b described above and shall be taken for given in the considerations below.

The flow resists of the fluid connections 14, 14-1, 14-2, 14-3, 14-4 are selected such that, when the inlet valves 8 connect the fluid providing systems 12 to the flow channel 2, the pressures at the inlet valves 8, 8-1, 8-2, 8-3, 8-4 are identical. For this purpose, the flow resists of the fluid connections 14, 14-1, 14-2, 14-3, 14-4 increase along the downstream direction as described above, in particular, when fluid pumps 46 are used, which provide a constant flow, such as the syringe pumps 46.

For each of the fluid providing systems 12, the flow resists of the fluid connections 80, 80-1, 80-2, 80-3, 80-4; 82, 82-1, 82-2, 82-3, 82-4 are selected such that the flow resist between the fluid pump 46 and the fluid reservoir 48 matches the flow resist between the fluid pump 46 and the reference point 50 when the inlet valve 8 connects the fluid providing system 12 to the flow channel 2.

This selection further reduces undesirable flows when the flow through the flow channel 2 is stopped.

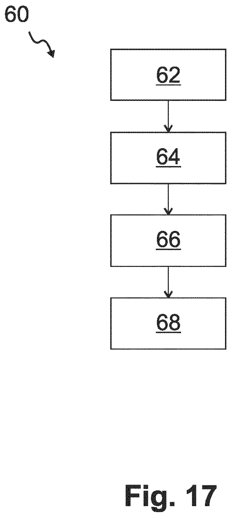

Fig. 17 illustrates a stop flow lithography method 60 for fabricating polymer particles.

The method 60 comprises providing 62 parallel flows of fluids 40, 40-1, 40-2, 40-3, 40-4 from a second flow channel 2b, wherein the parallel flows of the fluids 40, 40-1, 40-2, 40-3, 40-4 comprise at least one inner flow 40-2, 40-3 of a fluid comprising a photochemical precursor.

The method 60 further comprises receiving 64 the parallel flows of the fluids 40, 40-1, 40-2, 40-3, 40-4 in a first flow channel 2a, wherein the first flow channel 2a is formed above a lithographic mask 18 which is arranged above a substrate 16.

The method 60 further comprises stopping 66 the parallel flows of the fluids 40, 40-1, 40-2, 40-3, 40-4 using a valve 34, 8.

The method 60 further comprises providing (i.e., shining and/or guiding) 68 blue or UV light through the substrate 16 and the lithographic mask 18 into the first flow channel 2a to photopolymerize at least a portion of the photochemical precursor thus forming the polymer particles, wherein the blue or UV light comprises a wavelength in a wavelength range from 320 nm to 500 nm.

More specifically, the blue or UV light is provided when the flow is stopped (i.e., using the valve(s) 34, 8), and switched off or blocked when the flow is restarted (i.e., when the valves 34, 8 are opened). In some embodiments, the UV light is provided from a pulsed light source with a pulse duration of < 1 ms, and preferably with a pulse duration of < 0.1 ms or < 0.01 ms. In some embodiments, a single pulse is provided from the pulsed light source for the photopolymerization of the at least a portion of the photochemical precursor. The short pulse duration ensures that the photochemical precursor is photopolymerized in a short time interval corresponding to the pulse duration, and that the influence of a possibly remaining flow onto the shapes of the resulting polymer particles is minimized.

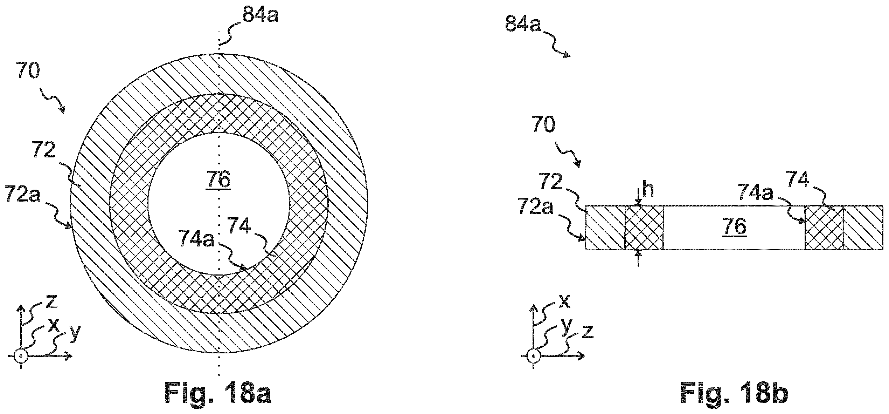

Fig. 18a, Fig. 18b illustrate a polymer particle 70 according to an embodiment, generated using the stop flow lithography apparatus 10 and/or the stop flow lithography method 60 described above. Fig. 18a gives a side view of the polymer particle 70. Fig. 18b gives a cross sectional view along the plane 84a indicated in Fig. 18a.

The polymer particle 70 comprises an inner section 74 and an outer section 72. One of the two is formed from a hydrophilic polymer, the other from a hydrophobic polymer.

Preferably, the inner section 74 is composed of a hydrophilic polymer and provides a hydrophilic surface 74a; and the outer section 72 is composed of a hydrophobic polymer and provides a hydrophobic surface 72a.

The inner section 74 is formed by photopolymerizing the flow 40-2 of Fig. 11 or Fig. 12b using the blue or UV light. The outer section 72 is formed by photopolymerizing the flow 40-3 of Fig. 11 or Fig. 12b using the blue or UV light.

A cavity 76 of the polymer particles 70 corresponds to the flow 40-1 of Fig. 11 or Fig. 12b.

The polymer particle 70 depicted in Fig. 18a, 18b has the shape of a hollow cylinder, i. e. an extrusion shape with a ring-shaped base. The shape of the base is controlled by selecting shapes and offsets of the nozzle structures 4, 4-1, 4-2, 4-3 as described in the context of Fig. 10a, Fig. 10b, Fig. 10c, Fig. 10d, Fig. 10e, Fig. 10f, Fig. 11, Fig. 12a, and Fig. 12b. The height h of the polymer particles 70 is determined by the widths of the slits, described in the context, e.g., of Fig. 3A.

Fig. 19a, Fig. 19b illustrate a polymer particle 70' according to another embodiment, generated using the stop flow lithography apparatus 10 and/or the stop flow lithography method 60 described above. Fig. 19a gives a side view of the polymer particle 70'. Fig. 19b gives a cross sectional view along the plane 84b indicated in Fig. 19a. A cross section of the polymer particle 70' of Fig. 19a along the plane 84a is given in Fig. 18b.

The polymer particle 70' is similar to the polymer particle 70 of Fig. 18a, Fig. 18b. However, the polymer particle 70' was fabricated using a lithographic mask 18, whose openings comprise first slit-shaped portions 20a and second slit-shaped portions 20b, 20b-1, 20b-2, 20b-3, 20b-4 as indicated in Fig. 3B.

The first slit-shaped portions 20a result in the fabrication of first portion 70 of the polymer particles 70'. The first portion 70 corresponds to the polymer particles 70 of Fig. 18a, Fig. 18b and is described in detail in the context of those figures.

The second portions 86-1, 86-2, 86-3, 86-4 result from the provision of the second slit-shaped portions 20b, 20b-1, 20b-2, 20b-3, 20b-4 in the manufacturing process, see Fig. 3B. In the depicted embodiment, four second portions 86-1, 86-2, 86-3, 86-4 are formed, but one, two, or three second portions 86-1, 86-2, 86-3, 86-4 may alternatively be formed by providing one, two, or three second slit-shaped portions 20b, 20b-1, 20b-2, 20b-3, 20b-4.

Figs. 20a, 20b illustrate the interaction of the polymer particle 70' with a hydrophilic droplet 88 in a hydrophobic fluid 90.

The hydrophilic droplet 88 is captured by the hydrophilic surface 74a and hence in the cavity 76. The hydrophilicity of the surface 74a holds the droplet 88 in this position.

The second portions 86-1, 86-2, 86-3, 86-4 of the polymer particle 70' are mechanically flexible, i.e., the angle between the second portions 86-1, 86-2, 86-3, 86-4 and the first portion 70 bend randomly in the absence of the droplet 88. As they encounter the droplet 88 during the initially random movement, they stick to the droplet 88 as the second portions 86-1, 86-2, 86-3, 86-4 are formed from the hydrophilic polymer and their surfaces are hydrophilic and thus stick to the hydrophilic droplet 88. This way, the droplet 88 is encapsulated in the polymer particle 70' for further analysis.

Fig. 20b illustrates a similar situation for a polymer particle 70' with only two second portions 86-1, 86-2. The lengths along the x directions (corresponding to the diameter of the base of the first portion 70) of the second portions 86-1, 86-2 of this polymer particle 70' are typically larger than the lengths of the second portions 86-1, 86-2, 86-3, 86-4 of the polymer particle of Fig. 20a, which correspond to half the diameter of the base of the first portion 70.

### LIST OF REFERENCE SIGNS

lithographic masking device 10a
stop flow lithography apparatus 10
substrate 16
lithographic mask 18
upper portion 30a
side portion 30b
bottom portion 30c
first flow channel 2a
first direction x
first thickness t1
second thickness t2
inner volume of the first flow channel 32
first valve 34
parallel-flow provider device 10b
second flow channel 2b
second direction x
inlet openings 6, 6-1, 6-2, 6-3, 6-4
nozzle structures 4, 4-1, 4-2, 4-3
nozzle structure outlets 4a, 4a-1, 4a-2, 4a-3
nozzle structure inlets 4b, 4b-1, 4b-2, 4b-3
nozzle structure bodies 4c, 4c-1, 4c-2, 4c-3
first inlet opening 6-1
second inlet opening 6-2
third inlet opening 6-3
fourth inlet opening 6-4
first nozzle structure inlet 4b-1
second nozzle structure inlet 4b-2
third nozzle structure inlet 4b-3
width/diameter of nozzle structure outlet w
inlet valves 8, 8-1, 8-2, 8-3, 8-4
fluid connections 14, 14-1, 14-2, 14-3, 14-4
flow diffusor 22
discs 36a, 36b, 36c
upper row 38A
lower row 38B
parallel flows of fluids 40-1, 40-2, 40-3, 40-4
center lines of the nozzle structures 42-1, 42-2, 42-3
first center line 44
single flow channel 2
fluid providing systems 12
fluid pump 46
fluid reservoir 48
reference point 50
fluid connection between the fluid pump and the fluid reservoir 80, 80-1, 80-2, 80-3, 80-4, 82
at least one inner flow 40-2, 40-3
flows controlled by three way valve 54a, 54b
stop flow lithography method 60
providing parallel flows of fluids from a second flow channel 62
receiving the parallel flows of the fluids in a first flow channel 64
stopping the parallel flows of the fluids using a valve 66
shining/guiding blue or UV light through the substrate and the lithographic mask into the first flow channel 68
polymer particle 70
outer section; hydrophilic/hydrophobic material 72
outer surface; hydrophilic/hydrophobic surface 72a
inner section; complementary hydrophobic/hydrophilic material 74
inner surface; complementary hydrophobic/hydrophilic surface 74a
cavity 76
inner side walls 78
cuts 84a, 84b
second portions of polymer particles 86, 86-1, 86-2, 86-3, 86-4
droplet 88
lipophilic/hydrophobic fluid 90

## Claims

1. A lithographic masking device (10a) for a stop flow lithography apparatus (10), the lithographic masking device (10a) comprising:
a substrate (16), wherein the substrate (16) is adapted to transmit blue or UV light, wherein the blue or UV light comprises a wavelength in a wavelength range from 320 nm to 500 nm;
a lithographic mask (18) arranged above the substrate (16); and
a first flow channel (2a) defining an inner volume (32) thereof;
wherein side portions (30b) and an upper portion (30a) of the first flow channel (2a) are arranged above the substrate (16), such that the inner volume (32) of the first flow channel (2a) is arranged above the lithographic mask (18) and that a shortest distance between the lithographic mask (18) and the inner volume (32) of the first flow channel (2a) is at most 30 µm.

2. The lithographic masking device (10a) according to claim 1,
wherein the inner volume (32) of the first flow channel (2a) is in direct physical contact with the lithographic mask (18);
and/or:
wherein the lithographic mask (18) is arranged inside the inner volume (32) of the first flow channel (2a).

3. The lithographic masking device (10a) according to claim 1 or 2,
wherein the side portions (30b) and/or the upper portion (30a) of the first flow channel (2a) comprise(s) or is/are composed of a polymer material;
and/or:
wherein the side portions (30b) and/or the upper portion (30a) of the first flow channel (2a) are planar;
and/or:
wherein the first flow channel (2a) comprises a rectangular or quadratic inner cross section and/or outer cross section;
and/or:
wherein a footprint of the lithographic mask (18) on the substrate (16) is fully comprised in a footprint of the first flow channel (2a) on the substrate (16);
and/or:
wherein the lithographic mask (18) comprises openings (20) for transmitting the blue or UV light, and wherein a footprint of the openings (20) on the substrate (16) is fully comprised in a footprint of the first flow channel (2a) on the substrate (16), in particular between left and right inner walls (78) of the first flow channel (2a);
and/or:
wherein the first flow channel (2a) extends along a first direction (x) defined by a center line extending along the longitudinal direction of the first flow channel (2a) through its center, and wherein the lithographic mask (18) comprises openings (20);
wherein, optionally, the openings (20) comprise first slit-shaped portions (20a), wherein longitudinal axes of the first slit-shaped portions (20a) are orientated perpendicular to the first direction (x);
wherein, optionally, the openings (20) comprise second slit-shaped portions (20b, 20b-1, 20b-2, 20b-3, 20b-4), wherein the second slit-shaped portions (20b, 20b-1, 20b-2, 20b-3, 20b-4) are connected to the first slit-shaped portions (20a) and/or extend away from the first slit-shaped portions (20a);
wherein widths of the openings (20) and/or of the first slit-shaped portions (20a) and/or of the second slit-shaped portions (20b, 20b-1, 20b-2, 20b-3, 20b-4) are less than 100 µm.

4. The lithographic masking device (10a) according to any of the previous claims,
wherein the lithographic mask (18) comprises or is composed of a metal, such as gold or silver, or of ZnO;
and/or:
wherein a thickness of the lithographic mask (18) is at most 1 µm;
and/or:
wherein the lithographic masking device (10a) further comprises a first valve (34) adapted to stop the parallel flows of the fluids (40,40-1,40-2,40-3,40-4), wherein, optionally, the first valve (34) is arranged in the first flow channel (2a) or in a downstream extension of the first flow channel (2a).

5. A parallel-flow provider device (10b) for providing parallel flows of fluids (40, 40-1, 40-2, 40-3, 40-4) for a stop flow lithography apparatus (10), the parallel-flow provider device (10b) comprising:
a second flow channel (2b), comprising at least four inlet openings (6, 6-1, 6-2, 6-3, 6-4) for introducing fluids into the second flow channel (2b), wherein the second flow channel (2b) extends along a second direction (x);
at least three nozzle structures (4, 4-1, 4-2, 4-3) arranged in the second flow channel (2b) in series along the second direction (x), the nozzle structures (4, 4-1, 4-2, 4-3) comprising respective nozzle structure outlets (4a, 4a-1, 4a-2, 4a-3), nozzle structure inlets (4b, 4b-1, 4b-2, 4b-3), and nozzle structure bodies (4c, 4c-1, 4c-2, 4c-3, 4c-4), the nozzle structure bodies (4c, 4c-1, 4c-2, 4c-3, 4c-4) providing fluid-connections between the nozzle structure inlets (4b, 4b-1, 4b-2, 4b-3) and the respective nozzle structure outlets (4a, 4a-1, 4a-2, 4a-3);
wherein the inlet openings (6, 6-1, 6-2, 6-3, 6-4) and the nozzle structure inlets (4b, 4b-1, 4b-2, 4b-3) are arranged alternatingly one after the other along the second direction (x).

6. The parallel-flow provider device (10b) according to claim 5,
wherein a width or a diameter of the nozzle structure outlets (4a, 4a-1, 4a-2, 4a-3) or of at least one of the nozzle structure outlets (4a, 4a-1, 4a-2, 4a-3) is in a range from 60 µm to 90 µm, or in a range from 65 µm to 85 µm, or in a range from 70 µm to 80 µm;
and/or:
wherein the parallel-flow provider device (10b) comprises fluid connections (14, 14-1, 14-2, 14-3, 14-4) to the inlet openings (6, 6-1, 6-2, 6-3, 6-4), wherein the inlet openings (6, 6-1,6-2,6-3,6-4) comprise a first, second, third, and fourth inlet opening arranged consecutively along a downstream direction of the second flow channel (2b), such that the first inlet opening (6-1) is the most upstream and the fourth inlet opening (6-4) is the most downstream, wherein the fluid connections (14, 14-1, 14-2, 14-3, 14-4) provide respective flow resists, and wherein the flow resists provided by the fluid connections (14, 14-1, 14-2, 14-3, 14-4) increase along the downstream direction, such that the fluid connection (14-1) to the first inlet opening (6-1) provides the smallest flow resist, and the fluid connection (14-4) to the fourth inlet opening (6-1) provides the largest flow resist;
wherein, optionally, the fluid connections (14, 14-1, 14-2, 14-3, 14-4) extend away from the inlet openings (6, 6-1, 6-2, 6-3, 6-4) and/or the parallel-flow provider device (10b) comprises at least three or at least four respective fluid connections (14, 14-1, 14-2, 14-3, 14-4);
and/or:
wherein the parallel-flow provider device (10b) further comprises at least two or at least three or at least four inlet valves (8, 8-1, 8-2, 8-3, 8-4), wherein each of the inlet valves (8,8-1, 8-2, 8-3, 8-4) is associated with, in particular fluid-connected to, a corresponding one of the inlet openings (6, 6-1, 6-2, 6-3, 6-4) for selectively stopping the introduction of the fluids into the second flow channel (2b) through the respective inlet openings (6, 6-1, 6-2, 6-3, 6-4);
wherein, optionally:
the fluid connections (14, 14-1, 14-2, 14-3, 14-4) to the inlet openings (6, 6-1, 6-2, 6-3, 6-4) comprise or are fluid connections (14, 14-1, 14-2, 14-3, 14-4) between the inlet valves (8, 8-1, 8-2, 8-3, 8-4) and the inlet openings (6, 6-1, 6-2, 6-3, 6-4);
and/or:
wherein the parallel-flow provider device (10b) further comprises a flow diffusor (22), wherein the flow diffusor (22) is arranged along the second direction (x) between any of the nozzle structure inlets (4b, 4b-1, 4b-2, 4b-3) and the nozzle structure outlet (4a, 4a-1, 4a-2, 4a-3) of the same nozzle structure (4, 4-1, 4-2, 4-3), such that an inlet opening (4b, 4b-1, 4b-2, 4b-3) is arranged along the second direction (x) between the flow diffusor (22) and said nozzle structure inlet (4b, 4b-1, 4b-2, 4b-3);
wherein, optionally:
the flow diffusor (22) comprises annular discs (36a, 36b, 36c) with openings, wherein the annular discs (36a, 36b, 36c) are arranged between the respective nozzle structure body (4c, 4c-1, 4c-2, 4c-3, 4c-4) and an inner wall of the second flow channel (2b), and wherein the openings of different annular discs (36a, 36b, 36c) of the same flow diffusor (22) are misaligned with each other;
and/or wherein, optionally:
the nozzle structures (4, 4-1, 4-2, 4-3) comprise a first, second, and third nozzle structure, and
the parallel-flow provider device (10b) comprises a respective flow diffusor (22) associated with the first nozzle structure (4-1), a respective flow diffusor (22) associated with the second nozzle structure (4-2), and/or a respective flow diffusor (22) associated with the third nozzle structure (4-3);
and/or:
wherein the nozzle structures (4, 4-1, 4-2, 4-3) and/or the flow diffusor(s) (22) and/or the second flow channel (2b) comprise(s) or is/are composed of a polymer.

7. The parallel-flow provider device (10b) according to claim 5 or 6, wherein the nozzle structures (4, 4-1, 4-2, 4-3) comprise a first, second, and third nozzle structure arranged consecutively along a downstream direction of the second flow channel (2b), such that first nozzle structure (4-1) is the most upstream and third nozzle structure (4-3) is the most downstream,
wherein the first nozzle structure (4-1) and the second nozzle structure (4-2) are spaced apart from each other along the second direction (x);
and/or:
wherein the second nozzle structure (4-2) and the third nozzle structure (4-3) are spaced apart from each other along the second direction (x);
and/or wherein:
the first nozzle structure (4-1) comprises an inner flow channel with a non-circular cross section; and/or
the nozzle structure outlet (4a-1) of the first nozzle structure (4-1) comprises a non-circular cross section; and/or
the second nozzle structure (4-2) comprises an inner channel with a non-circular cross section; and/or
the nozzle structure outlet (4a-2) of the second nozzle structure (4-2) comprises a non-circular cross section; and/or
the third nozzle structure (4-3) comprises an inner channel with a non-circular cross section; and/or
the nozzle structure outlet (4a-3) of the third nozzle structure (4-3) comprises a non-circular cross section.

8. The parallel-flow provider device (10b) according to any of claims 5 to 7,
wherein the nozzle structures (4, 4-1, 4-2, 4-3) comprise internal flow channels and center lines (42-1, 42-2, 42-3) extending along the internal flow channels in the centers of the internal flow channels, and wherein at least one pair of the nozzle structures (4, 4-1, 4-2, 4-3) is arranged with an offset between their respective center lines (42-1,42-2,42-3);
and/or wherein:
the second flow channel (2b) comprises a first center line (44) extending along the second direction (x) in the center of the second flow channel (2b),
the nozzle structures (4,4-1, 4-2,4-3) comprise internal flow channels and center lines (42-1, 42-2, 42-3) associated therewith, and
at least one or at least two of the nozzle structures (4-1, 4-2, 4-3) is/are arranged with an offset between the first center line (44) and the center line(s) associated with the respective internal flow channel(s).

9. A stop flow lithography apparatus (10) comprising the parallel-flow provider device (10b) according to any of claims 5 to 8, and the lithographic masking device (10a) according to any of claims 1 to 4, wherein the first flow channel (2a) and the second flow channel (2b) are fluid-connected.

10. The stop flow lithography apparatus (10) according to claim 9,
wherein the first flow channel (2a) and the second flow channel (2b) form a single flow channel (2), in particular a linear single flow channel (2);
and/or:
which further comprises a light source for generating blue or UV light, wherein the blue or UV light comprises a wavelength in a wavelength range from 320 nm to 500 nm; wherein, optionally, the light source is arranged to shine and/or guide the blue or UV light through the substrate (16) and the lithographic mask (18) into the first flow channel (2a), and/or wherein, optionally, the light source is a pulsed light source, in particular, with a pulse duration of < 1 ms, or with a pulse duration of < 0.1 ms, or with a pulse duration of < 0.01 ms;
and/or:
wherein the stop flow lithography apparatus further comprises the inlet valves (8, 8-1, 8-2, 8-3, 8-4) of claim 6, and fluid providing systems (12) fluid-connected to the inlet valves (8,8-1, 8-2, 8-3, 8-4), such that the stop flow lithography apparatus (10) is adapted to provide respective fluids from the fluid providing systems (12) to the respective associated inlet openings (6, 6-1, 6-2, 6-3, 6-4) selectively via the inlet valves (8, 8-1, 8-2, 8-3, 8-4);
wherein, optionally, the fluid providing systems (12) comprise respective fluid reservoirs (48), respective fluid pumps (46), and fluid connections (80, 82) between the respective fluid reservoirs (48) and the respective fluid pumps (46);
wherein, optionally:
the fluid pumps (46) are syringe pumps, and/or wherein the fluid pumps (46) are adapted to provide fluid currents which are controllable and/or temporarily constant;
and/or, wherein, optionally:
the stop flow lithography apparatus (10) comprises a reference point (50) arranged in the first flow channel (2a) above the lithographic mask (18); and
the fluid connections (80, 82) between the fluid pumps (46) and the fluid reservoirs (48) are formed such that their flow resists match the flow resists between the respective fluid pumps (46) and the reference point (50).

11. A stop flow lithography method (60) for fabricating polymer particles, the method comprising:
providing (62) parallel flows of fluids (40, 40-1, 40-2, 40-3, 40-4) from a second flow channel (2b), wherein the parallel flows of the fluids (40, 40-1, 40-2, 40-3, 40-4) comprise at least one inner flow (40-2, 40-3) of a fluid comprising a photochemical precursor;
receiving (64) the parallel flows of the fluids (40, 40-1, 40-2, 40-3, 40-4) in a first flow channel (2a), wherein the first flow channel (2a) is formed above a lithographic mask (18) which is arranged above a substrate (16);
stopping (68) the parallel flows of the fluids (40, 40-1, 40-2, 40-3, 40-4) using a valve (34, 8); and
providing blue or UV light through the substrate (16) and the lithographic mask (18) in the first flow channel (2a) to photopolymerize at least a portion of the photochemical precursor thus forming the polymer particles, wherein the blue or UV light comprises a wavelength in a wavelength range from 320 nm to 500 nm.

12. The stop flow lithography method (60) according to claim 11,
wherein the second flow channel (2b) comprises inlet openings (6, 6-1, 6-2, 6-3, 6-4),
wherein the providing (62) the parallel flows of fluids comprises introducing the fluids to the second flow channel (2b) through the inlet openings (6, 6-1, 6-2, 6-3, 6-4),
wherein inlet valves (8, 8-1, 8-2, 8-3, 8-4) are associated with the inlet openings (6, 6-1, 6-2, 6-3, 6-4),
wherein the stopping of the parallel flows of the fluids is performed using the inlet valves (8, 8-1, 8-2, 8-3, 8-4);
wherein, optionally:
the second flow channel (2b) extends along a second direction (x);
the parallel flows of the fluids (40, 40-1, 40-2, 40-3, 40-4) are provided in the second flow channel (2b) along the second direction (x) according to a downstream direction of the parallel flows of fluids (40, 40-1, 40-2, 40-3, 40-4);
the inlet openings (6, 6-1, 6-2, 6-3, 6-4) are arranged along the second direction (x) one after the other according to the following sequence in the downstream direction:
a first inlet opening (6-1), a second inlet opening (6-2), a third inlet opening (6-3), and a fourth inlet opening (6-4), and
wherein, in the process step of closing the inlet valves (8, 8-1, 8-2, 8-3, 8-4):
the inlet valve (8-1) associated with the first inlet opening (6-1) closes the first inlet (6-1) opening before the inlet valve (8-2) associated with the second inlet opening (6-2) closes the second inlet opening (6-2), and/or
the inlet valve (8-2) associated with the second inlet (6-2) opening closes the second inlet opening (6-2) before the inlet valve (8-3) associated with the third inlet opening (6-3) closes the third inlet opening (6-3), and/or
the inlet valve (8-3) associated with the third inlet opening (6-3) closes the third inlet opening (6-3) before the inlet valve (8-4) associated with the fourth inlet opening (6-4) closes the fourth inlet opening (6-4);
and/or:
wherein fluid providing systems (12) are fluid-connected to the inlet valves (8, 8-1, 8-2, 8-3, 8-4),
wherein the introducing the fluids to the second flow channel (2b) through the inlet openings (6, 6-1, 6-2, 6-3, 6-4) comprises fluid-connecting the fluid providing systems (12) to the inlet openings (6, 6-1, 6-2, 6-3, 6-4) to introduce the fluids to the second flow channel (2b) from the fluid providing systems (12) via the inlet valves (8, 8-1, 8-2, 8-3, 8-4),
wherein the closing the inlet valves (8, 8-1, 8-2, 8-3, 8-4) stops the introducing the fluids to the second flow channel (2b) from the fluid providing systems (12), and
wherein the method further comprises:
building up pressures in the fluid providing systems (12) to introduce the fluids from the fluid providing systems (12) to the second flow channel (2b);
wherein, optionally, the method further comprises maintaining the built-up pressures when the inlet valves (8, 8-1, 8-2, 8-3, 8-4) disconnect the fluid providing systems (12) from the inlet openings (6, 6-1, 6-2, 6-3, 6-4);
and/or wherein, optionally, the pressures are built up in the fluid providing systems (12) such that pressures at the inlet valves (8, 8-1, 8-2, 8-3, 8-4) match when the inlet valves (8, 8-1, 8-2, 8-3, 8-4) connect the fluid providing systems (12) to the inlet openings (6, 6-1, 6-2, 6-3, 6-4).

13. The method according to claim 11 or 12,
wherein a first valve (34) is provided in the first flow channel (2a) or in a downstream extension of the first flow channel (2a),
wherein the stopping the parallel flows of the fluids comprises closing the first valve (34), wherein the first valve (34) is closed after closing the inlet openings (6, 6-1, 6-2, 6-3, 6-4) using the inlet valves (8, 8-1, 8-2, 8-3, 8-4).

14. Polymer particles (70, 70') dispersed in a fluid, wherein sizes of the polymer particles (70, 70') are in a range from 80 to 95 µm along at least one direction.

15. The polymer particles according to claim 14,
wherein the polymer particles (70, 70') comprise first portions (70), the first portions (70) of the polymer particles (70, 70') corresponding to an extrusion of a base by a height (h), and wherein the sizes of the polymer particles (70, 70') refer to said height (h);
and/or:
wherein the polymer particles (70, 70') comprise second portions (86-1, 86-2, 86-3, 86-4) extending away from the first portions (70) and adapted for bending towards the first portions (70);
and/or:
wherein the particles comprise:
outer surfaces (72a); and
inner cavities (76) and inner surfaces (74a) associated with the inner cavities;
wherein one of the outer surfaces (72a) and the inner surfaces (74a) is hydrophilic and the other is hydrophobic, in particular wherein the inner surfaces (74a) are hydrophilic and the outer surfaces (72a) are hydrophobic.
